# EUROPEAN PATENT APPLICATION

(11) **EP 4 685 844 A1**
(43) Date of publication of application: **28.01.2026**
(21) Application number: 25188869.9
(22) Date of filing: 10.07.2025
(51) Int. Cl.: H01L 21/768, H01L 23/532

(54) **METALLIZATION STRUCTURE FOR ELECTRONIC DEVICES AND METHOD OF MANUFACTURING THE SAME**

(30) Priority: 26.07.2024 US 202418786263
(71) Applicant: STMicroelectronics International N.V., 1228 Plan-les-Ouates, Geneva (CH)
(72) Inventor: SCIARRILLO, Samuele, 20865 USMATE VELATE (MB) (IT); BRAMBILLA, Riccardo, 20842 BESANA IN BRIANZA (MB) (IT); VASSENA, Aurora, 23868 VALMADRERA (LC) (IT); BACCIAGLIA, Paola, 20876 ORNAGO (MB) (IT)
(74) Representative: Studio Torta S.p.A.

(57) **Abstract**

An electronic device, such as a semiconductor package, a semiconductor device, a semiconductor die, a semiconductor component, etc., includes metallization or conductive layers that are stacked on non-conductive layers to define electrical pathways through the electronic devices, as well as methods of manufacturing the same. The metallization structures are at least directed to formation of uniform conductive or metal vias of the metallization structure, and to reduce resistance to improve transportation of an electrical signal through the one or more embodiments of the metallization structures of the present disclosure. For example, the metallization structures may include one or more metallization or conductive layers and one or more non-conductive layers that are stacked on one another to provide electrical pathways with reduced resistance to improve electrical performance of the metallization structures.

## Description

### BACKGROUND

### Technical Field

The present disclosure is directed to a metallization structure of an electronic device (*e.g.,* a semiconductor device, package, component, etc.) that improves resistance, prevents short circuiting, and prevents cross-talk.

### Description of the Related Art

Electronic devices such as, for example, semiconductor packages, devices, and components, of various types generally include metallization or conductive structures that are structured and configured to provide an electrical pathway along which electrical signals are to pass through the electronic devices. The metallization structures generally include one or more metallization or conductive layers stacked on one each other. The one or more metallization and conductive layers may include conductive vias, conductive lines, conductive traces, or some other similar or like type of conductive structure along which an electrical signal may readily pass through. Generally, the metallization structures provide these electrical pathways such that electrical signals may be communicated throughout the electronic device, to the electronic device from an external component, or from the electronic device to the external component.

Generally, the metallization structures are formed on a base conductive layer, which may be a damascene layer, of the electronic device. These metallization structures are generally formed by forming and patterning one or more non-conductive or insulating layers on the base conductive layer. After the one or more non-conductive layers are patterned with openings, these openings are filled with a conductive material, usually in multiple successive steps, forming the metallization structures. At least one respective metallization structure of the metallization structures is in direct electrical communication or contact with a surface of the base conductive layer. The surface of the base conductive layer is relatively flat, however, small imperfections due to the surface of the base conductive layer being slightly rough still remain when forming the at least one respective metallization structure. For example, small hillocks or raised areas may be present at and along the surface of the base conductive layer. While forming the one or more metallization structures, undesired and unintended pillars of the conductive material are formed extending into at least one respective non-conductive layer of the one or more non-conductive layers due to the presence of the hillocks or raised areas at and along the surface of the base conductive layer. The underside and unintended pillars of conductive material being formed generally may result in cross-talk or short circuiting resulting in the electronic device not functioning within desired tolerances or not functioning at all, or may result in increased resistance such that electrical signals do not pass as easily and readily through the electrical pathway defined by the one or more metallization structures.

### BRIEF SUMMARY

The invention relates to a method and a device, as defined in the annexed claims.

The present disclosure is directed to one or more embodiments of electronic devices (e.g., semiconductor packages, semiconductor devices, semiconductor dice, semiconductor components, etc.) including metallization or conductive layers that are stacked on non-conductive layers to define electrical pathways through the electronic devices, as well as methods of manufacturing the same. The one or more embodiments of the metallization structures of the present disclosure are at least directed to formation of uniform conductive or metal vias of the metallization structure, and to reduce resistance to improve transportation of an electrical signal through the one or more embodiments of the metallization structures of the present disclosure.

For example, at least one embodiment of an electronic device of the present disclosure may be summarized as follows. The at least one embodiment of the electronic device includes a first metallization layer having a surface. A first dielectric layer is on the surface of the first metallization layer. An intermetal dielectric layer is on the first dielectric layer. A second dielectric layer is on the intermetal dielectric layer. An interlayer dielectric layer is on the second dielectric layer. A second metallization layer extends into and through the second dielectric layer, the intermetal dielectric layer, and the first dielectric layer. A third metallization layer extends through the interlayer dielectric layer to the second dielectric layer and the second metallization layer, the third metallization layer abuts the second dielectric layer, and the third metallization layer is in electrical communication with the first metallization layer through the second metallization layer, and the third metallization layer is separated from the intermetal dielectric layer by the second dielectric layer.

### BRIEF DESCRIPTION OF THE SEVERAL VIEWS OF THE DRAWINGS

For a better understanding of the embodiments, reference will now be made by way of example to the accompanying drawings. In the drawings, identical reference numbers identify the same or similar elements or acts unless the context indicates otherwise. The sizes and relative proportions of the elements in the drawings are not necessarily drawn to scale. For example, some of these elements may be enlarged and positioned to improve drawing legibility.
Figure 1A is a cross-sectional view of a metallization structure at a first region of an electronic device;
Figure 1B is a cross-sectional view of the metallization structure at a second region of the electronic device;
Figure 2A is a cross-sectional view of the metallization structure at a third region of the electronic device;
Figure 2B is a zoomed in, enhanced cross-sectional view of section 2B-2B as shown in Figure 2A of the metallization structure at the third region of the electronic device;
Figure 3 is a zoomed in, enhanced cross-sectional view during an intermediate process in forming the metallization structure as shown in Figures 2A and 2B;
Figure 4A is a cross-sectional view of an embodiment of a metallization structure at a first region of an electronic device of the present disclosure;
Figure 4B is a cross-sectional view of the embodiment of the metallization structure as shown in Figure 4A at a second region of the electronic device of the present disclosure;
Figure 5A is a cross-sectional view of an alternative embodiment of the metallization structure at a first region of an electronic device of the present disclosure;
Figure 5B is a cross-sectional view of the alternative embodiment of the metallization structure as shown in Figure 5A at a second region of the electronic device of the present disclosure;
Figure 6A is a cross-sectional view of another alternative embodiment of a metallization structure at a first region of an electronic device of the present disclosure;
Figure 6B is a cross-sectional view of the another alternative embodiment of the metallization structure as shown in Figure 6A at a second region of the electronic device of the present disclosure;
Figure 7 is a flowchart of an embodiment of a method of manufacturing the embodiment of the metallization structure as shown in Figures 4A and 4B of the present disclosure;
Figures 8A-8D are cross-sectional views of respective steps of the embodiment of the method of manufacturing of the flowchart as shown in Figure 7 of the present disclosure;
Figure 9 is a flowchart of an alternative embodiment of a method of manufacturing the alternative embodiment of the metallization structure as shown in Figures 5A and 5B of the present disclosure;
Figures 10A-10E are cross-sectional views of respective steps of the alternative embodiment of the method of manufacturing of the flowchart as shown in Figure 9 of the present disclosure;
Figure 11 is a flowchart of another alternative embodiment of a method of manufacturing the embodiment of the metallization structure as shown in Figures 6A and 6B of the present disclosure;
Figures 12A-12E are cross-sectional views of respective steps of the another alternative embodiment of the method of manufacturing the flowchart as shown in Figure 11 of the present disclosure;
Figure 13A is a cross-sectional view of forming one or more via openings at a first region of an electronic device;
Figure 13B is a cross-sectional view of forming the one or more via openings at a second region of the electronic device as shown in Figure 13A;
Figure 14A is a cross-sectional view of an embodiment of forming one or more via openings at a first region of an electronic device of the present disclosure;
Figure 14B is a cross-sectional view of the embodiment of forming the one or more via openings at a second region of the electronic device as shown in Figure 14A of the present disclosure;
Figure 15A is a cross-sectional view of an embodiment of forming one or more via openings at a first region of an electronic device of the present disclosure;
Figure 15B is a cross-sectional view of the embodiment of forming the one or more via openings at a second region of the electronic device as shown in Figure 15A of the present disclosure;
Figure 16A is a cross-sectional view of an embodiment of forming one or more via openings at a first region of an electronic device of the present disclosure; and
Figure 16B is a cross-sectional view of the embodiment of forming the one or more via openings at a second region of the electronic device as shown in Figure 16A of the present disclosure.

### DETAILED DESCRIPTION

In the following description, certain specific details are set forth in order to provide a thorough understanding of various embodiments of the disclosure. However, one skilled in the art will understand that the disclosure may be practiced without these specific details. In other instances, well-known structures associated with electronic security components, electronic security devices, security key cards, or credit/debit card fabrication techniques have not been described in detail to avoid unnecessarily obscuring the descriptions of the embodiments of the present disclosure.

Unless the context requires otherwise, throughout the specification and claims that follow, the word "comprise" and variations thereof, such as "comprises" and "comprising," are to be construed in an open, inclusive sense, that is, as "including, but not limited to."

The use of ordinals such as first, second, third, etc., does not necessarily imply a ranked sense of order, but rather may only distinguish between multiple instances of an act or a similar structure or material.

Reference throughout this specification to "one embodiment" or "an embodiment" means that a particular feature, structure, or characteristic described in connection with the embodiment is included in at least one embodiment. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

The terms "top," "bottom," "left," and "right," are used only for discussion purposes based on the orientation of the components in the discussion of the figures in the present disclosure as follows. These terms are not limiting as to the possible positions explicitly disclosed, implicitly disclosed, or inherently disclosed in the present disclosure.

The term "substantially" is used to clarify that there may be slight differences and variations when a package is manufactured in the real world, as nothing can be made perfectly equal or perfectly the same. In other words, "substantially" means and represents that there may be some slight variation in actual practice and instead is made or manufactured within selected tolerances.

As used in this specification and the appended claims, the singular forms "a," "an," and "the" include plural referents unless the content clearly dictates otherwise.

The term "transverse" is used to indicate that one feature is at an angle relative to another feature. For example, the angle may be any angle greater than zero (0) degrees such that one feature is at an angle relative to the other feature. In other words, the angle may be an obtuse angle, an acute angle, or a perpendicular or orthogonal angle (*i.e.,* ninety (90) degrees).

While one or more embodiments of various respective metallization or conductive layers and non-conductive or insulating layers are shown and described within the present disclosure, it will be readily appreciated that the invention are not limited thereto. In various embodiments, the structures, devices, methods and the like described herein may be embodied in or otherwise utilized in any suitable type of form of electronic device (e.g., semiconductor devices, semiconductor components, semiconductor dice, semiconductor packages, etc.).

The present disclosure is directed to one or more metallization or conductive layers and one or more insulating or non-conductive layers that are stacked on each other to form metallization structures within an electronic device *(e.g.,* a semiconductor device, a semiconductor component, semiconductor dice, semiconductor package, etc.) to prevent or reduce the likelihood of forming pillar defects within respective layers of the metallization structures to prevent short-circuiting, to prevent cross-talk, and to improve efficiency in the functionality of the metallization structures. Furthermore, the present disclosure is directed to one or more embodiments of methods of manufacturing the one or more metallization or conducive layers and one or more insulating or non-conductive layers that are stacked on each other to prevent or reduce the likelihood of forming pillar defects that cause short-circuiting and that cause cross-talk to further improve efficiency in the functionality of the metallization structures. The present disclosure is directed to providing a method of manufacturing these various metallization structures including conductive vias that are not tapered to reduce a resistance along an electrical pathway to improve overall functionality and efficiency of the electronic devices in which the metallization structures are present. In other words, as will become readily apparent from the following discussion herein, the present disclosure is directed to improving (e.g., reducing) an efficiency and reducing a resistance of the one or more metallization layers while preventing formation of defects resulting in increased resistance, short circuiting, or cross-talk along the electrical pathway that extends along the one or more metallization layers of the various embodiments of the metallization structures of the present disclosure. Furthermore, the present disclosure is directed to providing relatively vertical or uniform conductive vias within the various embodiments of the metallization structures of the present disclosure. Preventing or reducing the likelihood of increased resistance, short circuiting, or cross-talk and providing relatively vertical or uniform conductive vias within the various embodiments of the metallization structures of the present disclosure will improve efficiency and functionality of the various embodiments of the metallization structures of the present disclosure as compared to conventional metallization structures known to the semiconductor industry.

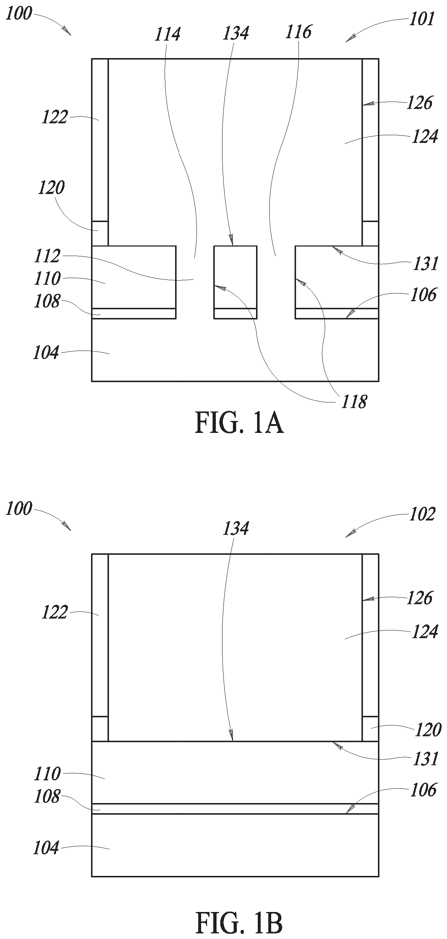

Figure 1A is a cross-sectional view of a metallization structure 100 at a first region 101 of an electronic device. Figure 1B is a cross-sectional view of the metallization structure 100 at a second region 102 of the electronic device. For example, the first region 101 is a central region of the electronic device that is spaced inward from sidewalls or edges of the electronic device *(e.g.,* a semiconductor device, a semiconductor package, a semiconductor component, etc.), and the second region 102 is a peripheral region spaced outward from the central region that is in close proximity or adjacent to the sidewalls or the edges of the electronic device. The second region 102 is positioned between the first region 101 (*i.e.,* the central region) and the sidewalls or edges of the electronic device.

As shown in Figure 1A, the metallization structure includes a first metallization layer 104 including a first surface 106. A first dielectric layer 108 is on and covers the first surface 106 of the first metallization layer 104. The first dielectric layer 108 is made of a nitride material, preferably a silicon nitride (SiN) material. In some alternatives, the first dielectric layer 108 is made of at least one of the following of SiCN, SiON, AlN, HfO2, HfAlO, or some other suitable or like type of material for the first dielectric layer 108. An intermetal dielectric (IMD) layer 110 is on and covers the first dielectric layer 108. The intermetal dielectric layer 110 is an oxide material, for example and preferably, a silicon-based oxide material, and more preferably a silicon oxide. Preferably the thickness of the IMD layer 110 is in the range of 150-1000 nanometers (nm), preferably 200-800 nanometers (nm), more preferably 250-700 nanometers (nm). In some embodiments, the thickness of the IMD is equal to the upper and lower ends of these ranges.

The first dielectric layer 108 acts as a barrier layer to avoid conductive or copper migration in the IMD layer 110 when forming a metallization structure or respective metallization layers.

The IMD layer 110 is preferably made of the silicon-based oxide material, more preferably a silicon oxide material, to minimize a thickness of the IMD layer 110 since the silicon-based oxide material has a strong dielectric constant relative to other dielectric materials. The IMD layer 110 acts as an etch stop layer.

A second metallization layer 112 extends into and through the first dielectric layer 108 and the intermetal dielectric (IMD) layer 110. The second metallization layer 112 includes a first conductive via 114 and a second conductive via 116. The first and second conductive vias 114, 116 include one or more sidewalls 118. The one or more sidewalls 118 of the first and second conductive vias 114, 116 are covered by the first dielectric layer 108 and the intermetal dielectric layer 110.

A second dielectric layer 120 is on the intermetal dielectric layer 110, and an interlayer dielectric (ILD) layer 122 is on the second dielectric layer 120. The second dielectric layer 120 is made of a nitride material, preferably a silicon nitride (SiN) material. The interlayer dielectric layer 122 is made of an oxide material, for example and preferably, a silicon-based oxide material, and more preferably a silicon oxide material. A third metallization layer 124 extends into and through the interlayer dielectric layer 122 and into and through the second dielectric layer 120 to the intermetal dielectric layer 110. The third metallization layer 124 includes one or more sidewalls 126 that are at least partially covered by the interlayer dielectric layer 122 and at least partially covered by the second dielectric layer 120.

As shown in Figure 1B, the second metallization layer 112 is not present at the second region such that no respective conductive vias are present at the second region. The surface 106 of the first metallization layer 104 is covered by the first dielectric layer 108, and the intermetal dielectric layer 110 covers the first dielectric layer 106. The second dielectric layer 120 is on the intermetal dielectric layer 110 and at least partially covers the one or more sidewalls 126 of the first metallization layer 104. The interlayer dielectric layer 122 is on the second dielectric layer 120 and at least partially covers the one or more sidewalls 126 of the first metallization layer 104. The third metallization layer 124 extends through the interlayer dielectric layer 122 and the second dielectric layer 120 to the intermetal dielectric layer 110 such that the third metallization layer 124 is on the second dielectric layer 120. At the second region as shown in Figure 1B, the third metallization layer 124 is spaced apart from the first metallization layer 104 by the intermetal dielectric layer 110 and the first dielectric layer 108.

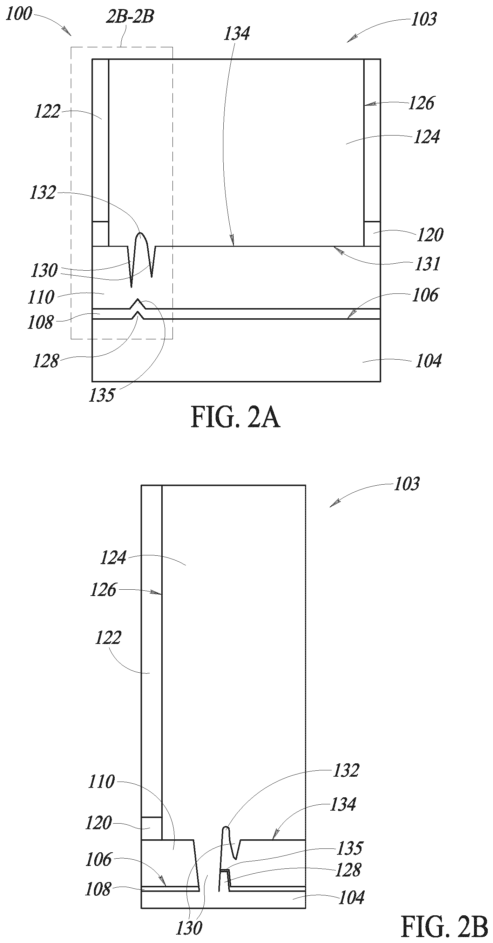

Figure 2A is a cross-sectional view of the metallization structure 100 at a third region 103 of the electronic device. The third region 103 is within a peripheral region similar to the second region 102. However, the third region 103 is spaced apart from the second region 102 such that the third region 103 is within the peripheral region but at a location different from the second region 102.

A hillock or raised area 128 is present along the surface 106 of the first metallization layer 104. The presence of the hillock 128 at the surface 106 of the first metallization layer 104 increases the likelihood of forming one or more pillar defects 130 that extend outward from a surface 131 of the third metallization layer 124 when manufacturing the metallization structure 100 at the third region. When the one or more pillar defects 130 occur as shown in Figure 2A, there is a high likelihood of cross-talk or short circuiting between the one or more pillar defects 130 and the surface 106 of the first metallization layer 104. When the one or more pillar defects 130 occur as shown in Figure 2A, a resistance along the third metallization layer 124 is increased, and this increase in resistance along the third metallization layer 124 reduces efficiency and accuracy in an electrical signal being transmitted along an electrical pathway including the third metallization layer 124. This short circuiting, cross-talk, and increased resistance that effects efficiency of transmission and accuracy of transmission of an electrical signal results in reduced functionality of the electronic device in which the one or more pillar defects 130 have occurred.

While not shown herein, respective one or more pillar defects similar to the one or more pillar defects 130 could similarly occur at the first region when a respective hillock similar to the hillock 128 is present along the surface 106 of the first metallization layer 104 at the first region 101. As a result of the respective hillock being present along the surface 106 of the first metallization layer 104 at the first region 101, the respective one or more pillars have an increased likelihood of occurring at and along the surface 131 of the third metallization layer 124. When the respective one or more pillars occur at and along the surface 131 at the first region 101, the respective one or more pillars may also short circuit or cross-talk with the conductive vias 114, 116 of the second metallization layer 112 in addition to potentially short circuiting and cross-talking with the first metallization layer 104.

The one or more pillar defects 130 are formed extending into the intermetal dielectric layer 110 due to a corresponding raised area or portion 132 being present at a location along a surface 134 of the intermetal dielectric layer aligned with and corresponding to the hillock 128 along the surface 106 of the first metallization layer 104. As the first dielectric layer 108 is on and covers the surface 106 of the first metallization layer 104, the first dielectric layer 108 includes a raised area or portion 135. The raised portion 132 of the intermetal dielectric layer 110, the raised portion 132 of the first dielectric layer 108, and the hillock 128 of the first metallization layer 104 are aligned with each other as the raised portion 132 of the intermetal dielectric layer 110 and the raised portion 135 of the first dielectric layer 108 are formed as a result of the presence of the hillock 128 along the surface 106 of the first metallization layer 104. In other words, the raised portion 135 of the first dielectric layer 108 is formed when forming the first dielectric layer 108 on the surface 106 of the first metallization layer 104, and the raised portion 132 of the intermetal dielectric layer 110 is formed when forming the intermetal dielectric layer 110 on the first dielectric layer 108.

Figure 2B is a zoomed in, enhanced cross-sectional view of the metallization structure 100 at the third region 103 of the electronic device taken at section 2B-2B as shown in Figure 2A in which alternatives of the one or more pillar defects 130 are present. Unlike Figure 2A in which the one or more pillar defects 130 extend into the intermetal dielectric layer 110 and terminate within the intermetal dielectric layer 110 before reaching the first dielectric layer 108 and the first metallization layer 104, in this alternative of the one or more pillar defects 130, at least one respective pillar of the one or more pillar defects 130 extends into and fully through the intermetal dielectric layer 110 to the first dielectric layer 108 and to the first metallization layer 104. In this alternative, the at least one respective pillar of the one or more pillar defects 130 extends through the first dielectric layer 108 and abuts the surface 106 of the first metallization layer 104, resulting in a short circuit between the first metallization layer 104 and the third metallization layer 124 at the third region 103. Similar to the issues with the one or more pillars as shown in Figure 2A, the same issues occur as a result of the at least one respective pillar of the one or more pillar defects 130 extending fully through the intermetal dielectric layer 110 and the first dielectric layer 108 and coming into contact with the surface 106 of the first metallization layer 104.

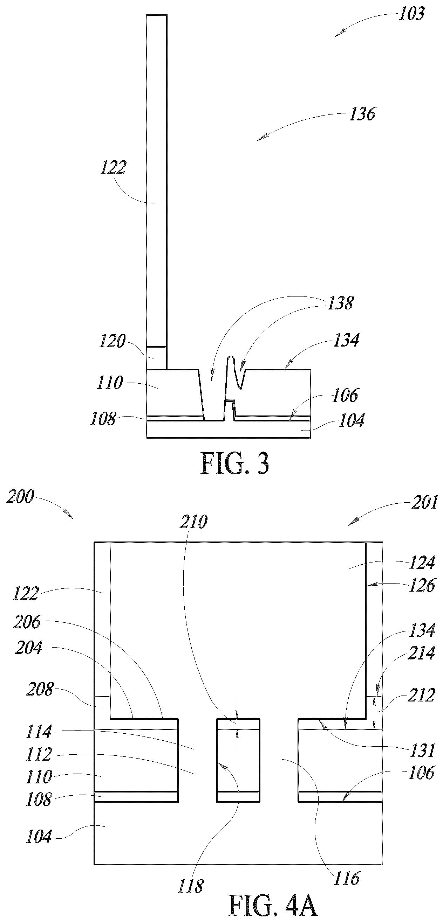

Figure 3 is a zoomed in, enhanced cross-sectional view of the metallization structure 100 at the third region 103 of the electronic device before the alternative of the one or more pillar defects 130 as shown in Figure 2B are formed. As shown in Figure 3, a first recess 136 has been formed extending through the interlayer dielectric layer 122 and the second dielectric layer 120. The first recess 136 generally is formed by performing one or more removal steps, which, for example, in at least one situation are one or more etching steps. Performing the one or more removal steps to remove respective portions of the interlayer dielectric layer 122 and the second dielectric layer 120 results in forming the first recess 136 as shown in Figure 3. When performing the one or more removal steps, the presence of the hillock 128 at the surface 106 of the first metallization layer 104, the raised portion 135 of the first dielectric layer 108, and the raised portion 132 of the intermetal dielectric layer 110 results in the one or more removal steps removing unintended respective portions of the intermetal dielectric layer 110, resulting in forming one or more pillar defect recesses 138. After the one or more removal steps have been performed, the third metallization layer 124 is formed within the first recess 136 and the one or more pillar defect recesses 138 resulting in the metallization structure 100 having the structure as shown in Figure 2B. Again, the one or more pillar defects 130 as shown in Figure 2B result in the short circuit between the first metallization layer 104 and the third metallization layer 124 due to the at least one respective pillar defect of the one or more pillar defects 130 coming into contact with the surface 106 of the first metallization layer 104.

In view of the above discussion, the present disclosure is directed to providing one or more embodiments of a metallization structure to prevent forming the one or more pillar defects 130 as discussed above to decrease resistance of an electrical pathway along which an electrical signal is to travel along, as well as to prevent or reduce the likelihood of cross-talk or short circuiting between various metallization layers of the metallization structure. The details of these one or more embodiments of the metallization structure will be discussed later herein.

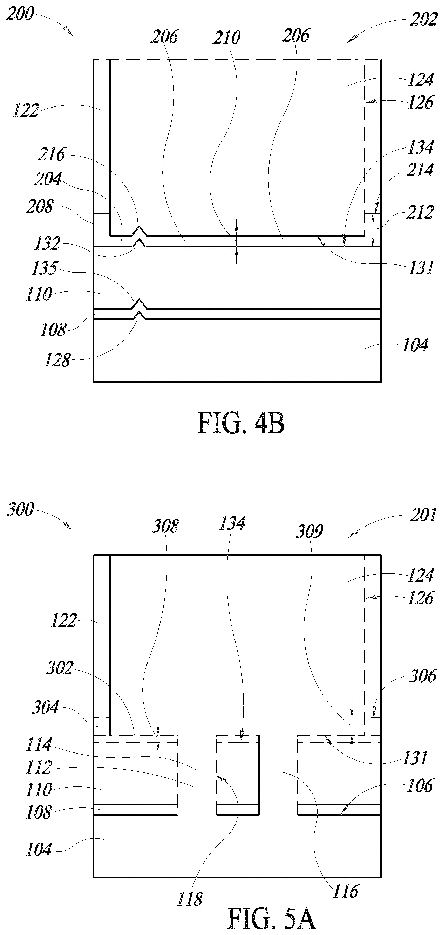

Figure 4A is a cross-sectional view of an embodiment of a metallization structure 200 at a first region 201 of an electronic device of the present disclosure. Figure 4B is a cross-sectional view of the embodiment of the metallization structure 200 at a second region 202 of the electronic device of the present disclosure. For example, the first region 201 is the same or similar to the first region 101 as the first region 201 is a central region of the electronic device that is spaced inward from sidewalls or edges of the electronic device (*e.g.,* a semiconductor device, a semiconductor package, a semiconductor component, etc.). For example, the second region 202 is the same or similar to the second region 102 as the second region 202 is a peripheral region spaced outward from the central region that is in close proximity or adjacent to the sidewalls or the edges of the electronic device. The second region 202 is positioned between the first region 201 (*i.e.,* the central region) and the sidewalls or edges of the electronic device. As this embodiment of the metallization structure 200 includes several of the same or similar features as the metallization structure 100 as discussed earlier herein, the same or similar features of the metallization structure 200 relative to the metallization structure 100 have been provided with the same or similar reference numerals. For the sake of brevity and simplicity of the present disclosure, the following discussion of the metallization structure 200 will focus on the additional or different features within the metallization structure 200 relative to the metallization structure 100.

As shown in Figure 4A, the metallization structure 200 includes the first metallization layer 104, the first dielectric layer 108 on the surface 106 of the first metallization layer 104, and the intermetal dielectric layer 110 on the first dielectric layer 108. A protective dielectric layer, in this embodiment a single second dielectric layer 204, is on the surface 134 of the intermetal dielectric layer 110. The second dielectric layer 204 is preferably (entirely) made of a nitride material, more preferably a silicon nitride (SiN) material. The second dielectric layer 204 (or the protective dielectric layer) includes a first portion 206 that is on the surface 134 of the intermetal dielectric layer 110 and a second portion 208 that extends outward from the first portion 206 and away from the surface 134 of the intermetal dielectric layer 110. In other words, the second portion 208 is transverse to the first portion 206, and the second portion 208 protrudes from the first portion 206. In at least one embodiment, the second dielectric layer 204 has a chemical nature different from a chemical nature of the IMD layer 110. In at least one embodiment, the second dielectric layer 204 has a chemical nature different from a chemical nature of the ILD layer 122.

The third metallization layer 124 is on and abuts the first portion 206 of the second dielectric layer 204 (or the protective dielectric layer). The first portion 206 of the second dielectric layer 204 (or the protective dielectric layer) is between the surface 131 of the third metallization layer and the surface 134 of the intermetal dielectric layer 110. The first portion 206 separates the surface 131 of the third metallization layer 124 from the surface of the intermetal dielectric layer 110. The second portion 208 of the second dielectric layer 204 (or the protective dielectric layer) at least partially covers the one or more sidewalls 126 of the third metallization layer 124. The interlayer dielectric layer 122 at least partially covers the one or more sidewalls 126 of the third metallization layer 124. For example, in at least some embodiments of the metallization structure 200, a remaining portion of the one or more sidewalls 126 not covered by the second portion 208 of the second dielectric layer 204 (or the protective dielectric layer) is covered by the interlayer dielectric layer 122. The first portion 206 of the second dielectric layer 204 (or the protective dielectric layer) may be referred to as a central portion and the second portion 208 of the second dielectric layer 204 (or the protective dielectric layer) may be referred to as a peripheral portion.

The first portion 206 of the second dielectric layer 204 has a first dimension or thickness 210 that extends from the surface 134 of the intermetal dielectric layer 110 to the surface 131 of the third metallization layer 124. The first dimension 210 may be within a range from 20 nanometers (nm) to 150 nanometers, preferably within a range of 50-100 nanometers, or may be equal to the upper and lower ends of these ranges.

The second dielectric layer 204 (or the protective dielectric layer) at the second portion 208 of the second dielectric layer 204 has a second dimension 212 that extends from the surface 134 of the intermetal dielectric layer 110 to an end 214 of the second portion 208 of the second dielectric layer 204 (or the protective dielectric layer). The second dimension 212 may be within a range from 120 nanometers (nm), preferably 140 nanometers (nm), to 250 nanometers (nm), preferably 225 nanometers (nm), or may be equal to the upper and lower ends of these ranges.

The second metallization layer 112, which includes the first and second conductive vias 114, 116, extends through the first portion 206 of the second dielectric layer 204, the intermetal dielectric layer 110, and the first dielectric layer 108 to the first metallization layer 104. The second metallization layer 112 extends from the surface 131 of the third metallization layer 124 to the surface 106 of the first metallization layer 104. The second metallization layer 112 extending from the first metallization layer 104 to the third metallization layer 124 results in the first metallization layer 104 being in electrical communication with the third metallization layer 124 at the first region 201 through the second metallization layer 112.

The first and second conductive vias 114, 116 of the second metallization layer 112 include the one or more sidewalls 118. The one or more sidewalls 118 of the first and second conductive vias 114, 116 of the second metallization layer 112 are covered by the first dielectric layer 108, the intermetal dielectric layer 110, and the first portion 206 of the second dielectric layer 204 (or the protective dielectric layer).

As shown in Figure 4B, at the second region 202 of the electronic device, the second metallization layer 112 is not present at the second region 202. Instead, the third metallization layer 124 is spaced apart and separated from the first metallization layer 104 by the stack of the first dielectric layer 108, the intermetal dielectric layer 110, and the first portion 206 of the second dielectric layer 204 (or the protective dielectric layer). Unlike as shown in Figure 2B, the one or more pillar defects 130 do not occur at the second region 202 even with the presence of the hillock 128 at the first surface 106 of the first metallization layer 104.

The first dielectric layer 108 covers the hillock 128 at the surface 106 of the first metallization layer 104 such that the first dielectric layer 108 includes the raised portion 135. As a result of the hillock 128 and the raised portion 135 of the first dielectric layer 108, the raised portion 132 is present at the surface 134 of the intermetal dielectric layer. However, unlike the raised portion 132 being in direct contact and covered by the third metallization layer 124 as shown in Figures 2A and 2B of the present disclosure, the raised portion 132 at the surface 134 of the intermetal dielectric layer 110 is in direct contact and covered by the first portion 206 of the second dielectric layer 204 (or the protective dielectric layer). The first portion 206 of the second dielectric layer 204 (or the protective dielectric layer) includes a raised portion or area 216 that covers and abuts the raised portion 132 at the surface 134 of the intermetal dielectric layer 110. As shown in Figure 4B, as the raised portion 216 of the first portion 206 of the second dielectric layer 204 covers the raised portion 132 at the surface 134 of the intermetal dielectric layer 110, the one or more pillar defects 130 are prevented from being formed while manufacturing the metallization structure 200.

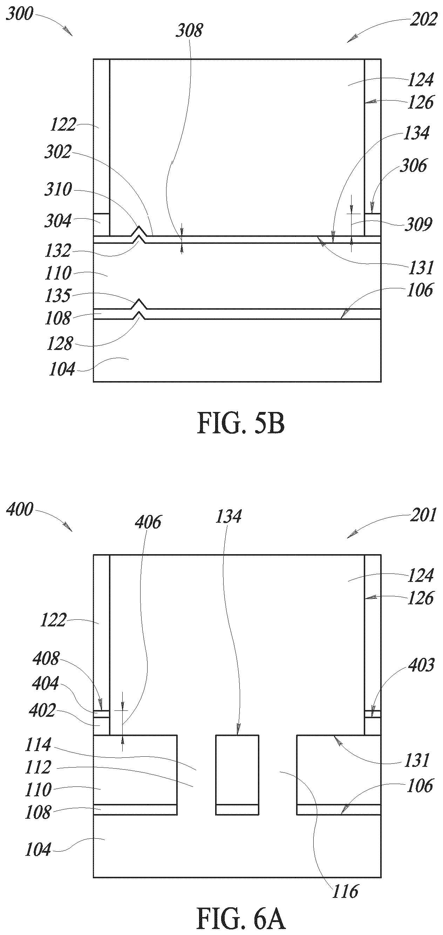

Figure 5A is a cross-sectional view of an alternative embodiment of a metallization structure 300 at the first region 201 of the electronic device of the present disclosure. Figure 5B is a cross-sectional view of the alternative embodiment of the metallization structure 300 at the second region 202 of the electronic device of the present disclosure.

As shown in Figure 5A, the metallization structure 300 includes a protective dielectric layer comprising a third dielectric layer 302 (or first dielectric sub-layer) that is on and covers the surface 134 of the intermetal dielectric layer 110, and a second dielectric layer 304 (or second dielectric sub-layer) that is on the third dielectric layer 302. In at least one embodiment, the third dielectric layer 302 (or first dielectric sub-layer) is made of an oxide material such as an aluminum oxide material (e.g., an aluminum oxide, Al₂O₃, material). In at least one alternative embodiment, the third dielectric layer 302 (or first dielectric sub-layer) is made of a hafnium oxide material (e.g., a hafnium oxide, HfO2, material or hafnium aluminate, HfAlO, material). In at least some other alternative embodiments, the third dielectric layer 302 (or first dielectric sub-layer) is a nitride material (*e.g.*, an aluminum nitride, AlN, material or a Titanium nitride, TiN, material). The second dielectric layer 304 (or second dielectric sub-layer) is made of a nitride material, preferably a silicon nitride (SiN) material. The second dielectric layer 304 (or second dielectric sub-layer) is spaced apart and separated from the surface 134 of the intermetal dielectric layer 110 by the third dielectric layer 302. Unlike the embodiment of the metallization structure 200 as shown in Figures 4A and 4B of the present disclosure that includes a protective dielectric layer made of a single layer of dielectric material (i.e., the second dielectric layer 204) with the first portion 206 and the second portion 208, the alternative embodiment of the metallization structure 300 includes a protective dielectric layer comprising a first dielectric sub-layer made of a hard material and a second dielectric sub-layer made of a softer dielectric material. For example, the third dielectric layer 302 is essentially a replacement for the first portion 206 of the second dielectric layer 204. In at least one embodiment, the second dielectric layer 304 (or second dielectric sub-layer) and the third dielectric layer 302 (or first dielectric sub-layer) have a chemical nature different from each other. In at least one embodiment the second and third dielectric layer (or second/first dielectric sub-layer) have a chemical nature different from a chemical nature of the IMD layer 110 and/or of the ILD layer 122.

The third dielectric layer 302 is on the surface 134 of the intermetal dielectric layer 110 and the second dielectric layer 304 extends outward from the third dielectric layer 302 and away from the surface 134 of the intermetal dielectric layer 110. In other words, the second dielectric layer 304 is transverse to the third dielectric layer 302, and the second dielectric layer 304 protrudes from the third dielectric layer 302.

The third dielectric layer (or first dielectric sub-layer) 302 has a third dimension 308 that extends from the surface 134 of the intermetal dielectric layer 110 to the surface 131 of the third metallization layer 124. The third dimension 308 may be within a range from 20 nanometers (nm) to 100 nanometers (nm), preferably 20-80 nanometers (nm), or may be equal to the upper and lower ends of these ranges.

The second dielectric layer 304 (or second dielectric sub-layer) may have a fourth dimension 309 that extends from the third dielectric layer 302 to the end 306 of the second dielectric layer 304. The fourth dimension 309 may be within a range from 120 nanometers (nm), preferably 140 nanometers (nm), to 250 nanometers (nm), preferably 225 nanometers (nm), or preferably within a range from 100-200 nanometers (nm) or may be equal to the upper and lower ends of these ranges. In some embodiments of the metallization structure 300, the fourth dimension 309 is greater than the third dimension 308.

As shown in Figure 5B, at the second region 202 of the electronic device, the second metallization layer 112 is not present at the second region 202, similarly to what has been shown in figure 4B. Instead, the third metallization layer 124 is spaced apart and separated from the first metallization layer 104 by the first dielectric layer 108, the intermetal dielectric layer 110, and the third dielectric layer 302. Unlike as shown in Figure 2B, the one or more pillar defects 130 do not occur at the second region 202 even with the presence of the hillock 128 at the first surface 106 of the first metallization layer 104.

Figure 6A is a cross-sectional view of another alternative embodiment of a metallization structure 400 at the first region 201 of the electronic device of the present disclosure. Figure 5B is a cross-sectional view of the another alternative embodiment of the metallization structure 400 of the electronic device of the present disclosure.

As shown in Figure 6A, the metallization structure 400 includes a protective dielectric layer comprising a second dielectric layer 402 (or third dielectric sub-layer) that is on the surface 134 of the intermetal dielectric layer 110, and a third dielectric layer 404 (or fourth dielectric sub-layer) that is on an end 403 of the second dielectric layer 402. The second dielectric layer 402 is made of a nitride material, preferably a silicon nitride (SiN) material. In at least one embodiment, the third dielectric layer 404 is made of an oxide material such as an aluminum oxide material (e.g., an Al₂O₃ material). In at least one alternative embodiment, the third dielectric layer is made of a hafnium oxide material (e.g., a HfO2 material or HfAlO material). In at least some other alternative embodiments, the third dielectric layer 302 is a nitride material (e.g., a AlN material or a TiN material). The third dielectric layer 404 is spaced apart from the surface 134 of the intermetal dielectric layer 110 by the second dielectric layer 402. Unlike the embodiment of the metallization structure 300 as shown in Figures 5A and 5B of the present disclosure that includes the third dielectric layer 302 between the surface 134 of the intermetal dielectric layer 110 and the surface 131 of the third metallization layer 124, the another alternative embodiment of the metallization structure 400 includes the third dielectric layer 404 on the end 403 of the second dielectric layer 402 such that the third dielectric layer 404 is spaced apart and separated from the surface 134 of the intermetal dielectric layer 110. Also, unlike the embodiment of the metallization structure 300 as shown in Figures 5A and 5B of the present disclosure that includes the third dielectric layer 302 between the surface 134 of the intermetal dielectric layer 110 and the surface 131 of the third metallization layer 124, the surface 131 of the third metallization layer 124 abuts and is on the surface 134 of the third metallization layer 124. In at least one embodiment, the second dielectric layer 402 and the third dielectric layer 404 have a chemical nature different from each other. In at least one embodiment the second dielectric layer 402 has a chemical nature different from a chemical nature of the IMD layer 110 and/or of the ILD layer 122.

The second dielectric layer 402 and the third dielectric layer 404 at least partially cover the one or more sidewalls 126 of the third metallization layer 124. The interlayer dielectric layer 122 at least partially covers the one or more sidewalls 126 of the third metallization layer 124.

In some embodiments, a thickness of the second dielectric layer 402 (or the third dielectric sub-layer) may be within the range from 120 nanometers (nm), preferably 140 nanometers (nm), to 250 nanometers (nm), preferably 225 nanometers (nm), or preferably within a range from 100-200 nanometers (nm), or may be equal to the upper and lower ends of these ranges..

In some embodiments, a thickness of the third dielectric layer 404 (or the fourth dielectric sub-layer) may be within a range from 20 nanometers (nm) to 100 nanometers (nm), preferably 20-80 nanometers (nm), or may be equal to the upper and lower ends of these ranges.

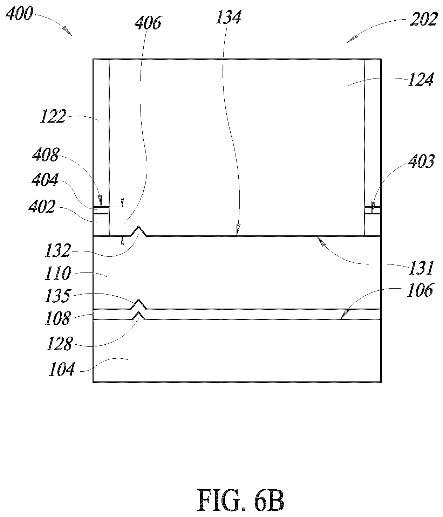

As shown in Figure 6B, at the second region 202 of the electronic device, the second metallization layer 112 is not present at the second region 202, similarly to what has been shown in figure 4B and 5B. Instead, the third metallization layer 124 is spaced apart and separated from the first metallization layer 104 by the first dielectric layer 108 and the intermetal dielectric layer 110. Unlike as shown in Figure 2B, the one or more pillar defects 130 do not occur at the second region 202 even with the presence of the hillock 128 at the first surface 106 of the first metallization layer 104.

In view of the above discussion with respect to the respective embodiments of the metallization structures 200, 300, 400 of the present disclosure, the discussion as follows herein will make it readily apparent how the protective dielectric layer prevents or reduces the likelihood of forming the one or more pillar defects as shown in Figures 2A, 2B, and 3 of the present disclosure, and/or of forming the conductive vias 114, 116 of the second metallization layer 112 without tapering to further improve a resistance of the metallization structures 200, 300, 400, respectively.

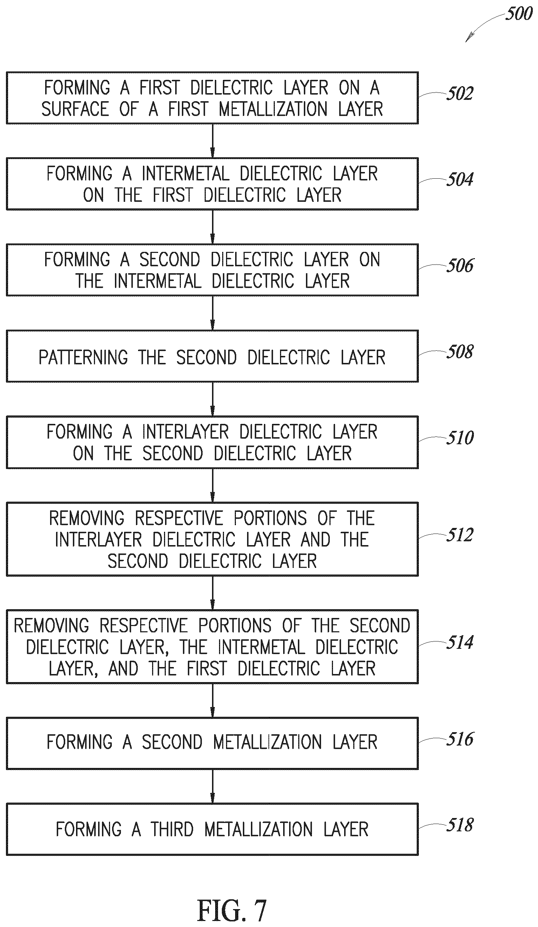

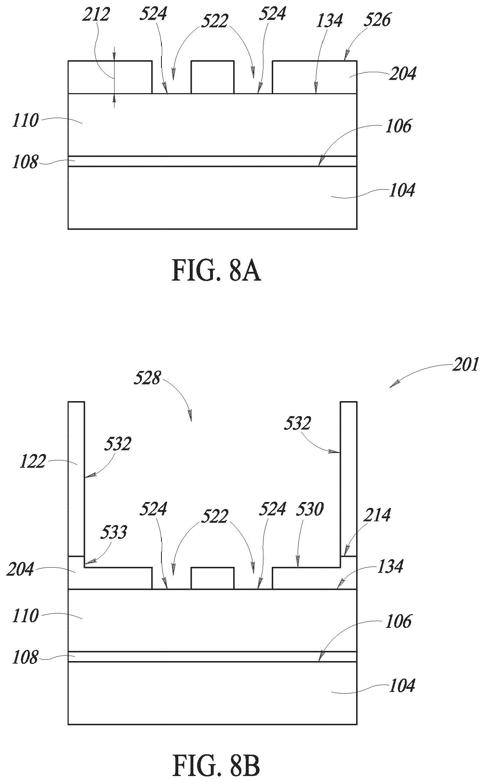

Figure 7 is directed to a flowchart 500 of an embodiment of a method of manufacturing the embodiment of the metallization structure 200 as shown in Figures 4A and 4B of the present disclosure. Figures 8A-8D are cross-sectional views of intermediate steps throughout the embodiment of the method of manufacturing of the flowchart 500 as shown in Figure 7. The flowchart 500 includes a first step 502, a second step 504, a third step 506, a fourth step 508, a fifth step 510, a sixth step 512, a seventh step 514, an eighth step 516, and a ninth step 518. In view of the discussion earlier herein with respect to the various features of the embodiment of the metallization structure 200 with respect to Figures 4A and 4B, the discussion of the respective steps 502, 504, 506, 508, 510, 512, 514, 516, 518 will utilize the reference numerals for the features as discussed earlier herein with respect to the metallization structure 200 as shown in Figures 4A and 4B as appropriate.

For clarity, in the following description, reference will be made to the second dielectric layer and third dielectric layer through all the process steps, without providing a dedicated name to each transformation these layers undergo from the start to the end of the method. For example, the second dielectric layer is obtained at the end of the method, and this layer is obtained (at least) by depositing a precursor layer of the second dielectric layer, forming one or more openings in the precursor layer to obtain an "opened precursor layer", and patterning the "opened" precursor layer to obtain the final second dielectric layer. This will be avoided to simplify the understanding of the following description.

In the first step 502, the first dielectric layer 108 is formed on the surface 106 of the first metallization layer 104. The first dielectric layer 108 may be formed by utilizing a deposition technique (e.g., CVD, Chemical Vapor Deposition) known within the semiconductor industry to form the first dielectric layer 108 on the surface 106 of the first metallization layer 104.

In the second step 504, the intermetal dielectric layer 110 is formed on the first dielectric layer 108 and fully covers the first dielectric layer 108. The intermetal dielectric layer 110 may be formed by utilizing a deposition technique (*e.g.*, CVD, Chemical Vapor Deposition) known within the semiconductor industry to form the intermetal dielectric layer 110 on the first dielectric layer 108.

In the third step 506, the second dielectric layer 204 (or the protective dielectric layer) is formed on the surface 134 of the intermetal dielectric layer 110. The second dielectric layer 204 is initially formed to fully cover the surface 134 of the intermetal dielectric layer 110. The second dielectric layer 204 may be formed by utilizing a deposition technique (e.g., CVD, Chemical Vapor Deposition) known within the semiconductor industry to form the second dielectric layer 204 on the surface 134 of the intermetal dielectric layer 110. The second dielectric layer 204 is initially deposited with a (constant) thickness along the width of the device in the range from 120 nanometers (nm), preferably 140 nanometers (nm), to 250 nanometers (nm), preferably 225 nanometers (nm), or may be equal to the upper and lower ends of these ranges. Preferably the second dielectric layer 204 has an initial thickness in the range from 180 nm to 210 nm. These ranges of the thickness allow to advantageously reduce the risk of Cu-hillocks formation and/or minimize the risk of any unwanted contact in case the Cu-hillocks form.

Preferably the second dielectric layer 204 is initially deposited with a thickness function of the thickness of the third metallization layer 124 that needs to be formed for the specific device. In a first example, in case the third metallization layer 124 has a thickness between 0.7 µm and 1.1 µm (preferably about 1 µm), the second dielectric layer 204 has a thickness between 120 nm and 160 nm (for example equal to about 140 nm). In a second example, in case the third metallization layer 124 has a thickness between 3.8 µm and 4.2 µm (preferably about 4 µm), the second dielectric layer 204 has a thickness between 200 nm and 250 nm (for example equal to about 225 nm).

Preferably the thickness of the first dielectric layer 108 is between 30 nm and 100 nm. Therefore, a ratio between the thicknesses of the second dielectric layer 204 and the first dielectric layer is greater than 1, preferably greater than or equal to 1.2. In a preferred embodiment, the second dielectric layer 204 has a thickness equal to about 140 nm and the first dielectric layer 108 has a thickness equal to about 40 nm (ratio of 3.5). In a further preferred embodiment, the second dielectric layer 204 has a thickness equal to about 225 nm and the first dielectric layer 108 has a thickness equal to about 100 nm (ratio of 2.25).

In the fourth step 508 (schematically shown in fig. 8A), the second dielectric layer 204 (or the protective dielectric layer) is patterned (e.g., through a dedicated pattern mask) at the first region 201 to form one or more openings 522 that expose one or more corresponding regions 524 of the surface 134 of the intermetal dielectric layer 110. The one or more openings 522 extend into a surface 526 of the second dielectric layer 204 and extend fully through the second dielectric layer 204 to the surface 134 of the intermetal dielectric layer 110 exposing the one or more regions 524. After the fourth step 508 is carried out forming the second dielectric layer 204, the second dielectric layer 204 (or the protective dielectric layer) has the second dimension 212 along its entirety at this stage of the embodiment of the method of manufacturing in the flowchart 500. The second dielectric layer 204 (or the protective dielectric layer) is not patterned with the one or more openings 522 at the second region 202 (i.e., the dedicated pattern mask does not present any openings at the second region 202). The second dielectric layer 204 may be patterned with the one or more openings 522 by forming a resist mask layer on the surface 526, patterning the resist mask layer with one or more openings corresponding to the one or more openings 522 to be formed, and then etching through the one or more openings in the resist mask layer to remove respective portions of the second dielectric layer 204 to form the one or more openings 522. After the one or more openings 522 have been formed, the resist mask layer is removed resulting in the intermediate structure as shown in Figure 8A.

In the fifth step 510, the interlayer dielectric layer 122 is formed on the surface 526 of the second dielectric layer 204 (or the protective dielectric layer), is formed within the one or more openings 522, and is formed on the one or more regions 524 of the surface 134 of the intermetal dielectric layer 110. The interlayer dielectric layer 122 may be formed by utilizing a deposition technique (e.g., CVD, Chemical Vapor Deposition) known within the semiconductor industry to form the interlayer dielectric layer 122 on the surface 526 of the second dielectric layer 204, in the one or more openings 522, and on the one or more regions 524 of the surface 134 of the intermetal dielectric layer 110.

In the sixth step 512 (as schematically shown in fig. 8B), respective portions of the interlayer dielectric layer 122 and the second dielectric layer 204 are removed. For example, in at least one embodiment, the interlayer dielectric layer 122 and the second dielectric layer 204 are exposed to an etchant chemical resulting in the respective portions of the interlayer dielectric layer 122 and the second dielectric layer 204 being etched away. The etching results in a recess 528 extending into and through the interlayer dielectric layer 122 to the second dielectric layer 204. The etching results in a first or initial portion of the second dielectric layer 204 being removed, which defines a first recessed surface 530 and defines the end 214 of what will be the second portion 208 of the second dielectric layer 204. The etching results in partially defining what will be the first portion 206 and what will be the second portion 208 of the second dielectric layer. The etching results in removing the interlayer dielectric layer 122 from the one or more openings 522 and re-exposing the one or more regions 524 of the surface 134 of the intermetal dielectric layer 110. The recess 528 defined and delimited between one or more sidewalls 532 of the interlayer dielectric layer 122, the first recessed surface 530 of the second dielectric layer 204, and one or more sidewalls 533 of the second dielectric layer 204. The intermediate structure formed as a result of carrying out the sixth step 512 may be readily seen in Figure 8B of the present disclosure. It is noted that the second dielectric layer does not undergo an "active" patterning (or etching). In fact, the second dielectric layer is used as etch stop layer, and it will be partially etched due to the intrinsic over-etching of each patterning/etching step. The specific chemical nature of the second dielectric layer different from the chemical nature of the ILD layer and of the IMD layer together with its minimum thickness (at least 120 nm) allows to advantageously obtain the desired benefits of Cu-hillocks reduction and of unwanted contacts limitation/avoidance.

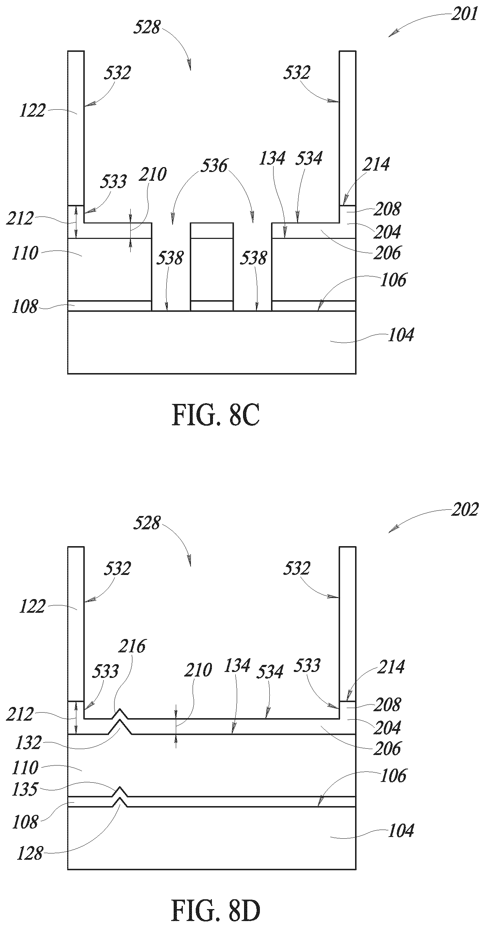

In the seventh step 514 (as shown in figure 8C), respective portions of the intermetal dielectric layer 110 and the second dielectric layer 204 are removed. For example, in at least one embodiment, the intermetal dielectric layer 110 and the second dielectric layer 204 are exposed to an etchant chemical resulting in respective portions of the intermetal dielectric layer 110 and the second dielectric layer 204 being etched away. This etching results in a second or successive portion of the second dielectric layer 204 being removed, which defines a second recessed surface 534. After that, a similar process is applied to remove respective portion of the first dielectric layer 108, thus exposing the first metallization layer 104. This fully defines the first portion 206 and the second portion 208 of the second dielectric layer 204. The second recessed surface 534 is a surface of the second dielectric layer on which the third metallization layer 124 will eventually be present. The etching results in the one or more sidewalls 533 being increased in size. The etching further results in forming and defining via openings 536 that extend through the second dielectric layer 204, the intermetal dielectric layer 110, and the first dielectric layer 108. The via openings 536 expose one or more regions 538 of the surface 106 of the first metallization layer 104. The via openings 536 are delimited and defined by respective sidewalls of the first dielectric layer 108, the intermetal dielectric layer 110, and the second dielectric layer 204. The intermediate structure at the first region 201 formed as a result of carrying out the seventh step 514 may be readily seen in Figure 8C of the present disclosure.

It will be readily appreciated that the first, second, third, fourth, fifth, sixth, and seventh steps 502, 504, 506, 508, 510, 512, 514 are carried out at the second region 202 as well. The results of carrying out these steps results in the intermediate structure as shown in Figure 8D. The intermediate structure formed by carrying out these respective steps at the second region 202 may be readily seen in Figure 8D.

After the embodiment of the method of manufacturing of the flowchart 500 is carried out to completion through the seventh step 514 at the first region 201 and the second region 202, in the eighth step 516, the second metallization layer 112 is formed within the via openings 522. The second metallization layer 112 may be formed with a deposition technique or techniques (e.g., PVD, Physical Vapor Deposition, combined with ECD, Electro Chemical Deposition) known to the semiconductor industry to form the second metallization layer 112 within the one or more via openings 536 forming the first and second conductive vias 114, 116 of the second metallization layer 112. The second metallization layer 112 is formed in the first region 201 but is not formed in the second region 202.

In the ninth step 518, the third metallization layer 124 is formed in the recesses 528 in the interlayer dielectric layer 122 at the first region 201 and the second region 202. The third metallization layer 124 may be formed with a deposition technique or techniques (e.g., PVD, Physical Vapor Deposition, combined with ECD, Electro Chemical Deposition) known to the semiconductor industry to form the third metallization layer 124 within the recesses 528 at the first and second regions 201, 202. At the first region 201, the third metallization is formed on the second recessed surface 534 of the second dielectric layer 204 and on the first and second conductive vias 114, 116 of the second metallization layer 112. At the second region 202, the third metallization layer 124 is formed on the second recessed surface 534 of the second dielectric layer 204 and is formed on the raised portion 216 of the second dielectric layer 204. After the ninth step 518 is carried out to completion, the metallization structure 200 is fully formed at the first region 201 and the second region 202 (see Figures 4A and 4B of the present disclosure).

While the eighth step 516 and the ninth step 518 are described as forming the second metallization layer 112 and the third metallization layer 124 at the first and second regions 201, 202, respectively, with respect to the embodiment of the method of the flowchart 500 as discussed above, in at least one alternative embodiment, the second metallization layer 112 and the third metallization layer 124 are formed at the same time such that there is the first metallization layer 104 and there is a second metallization layer that includes a first portion 112 and a second portion 124, which correspond to the second and third metallization layer, respectively. In other words, the eighth step 516 and the ninth step 518 are combined into a single step such that the vias 114, 116 at the first region 201 are formed (*e.g.,* filling the via openings 536) at the same time along with filling the recesses 528 at the first and second regions 201, 202.

In view of the above discussion, in at least one embodiment, the second and third metallization layers 112, 124, respectively, are formed together in a single deposition step at the same time, which may be referred to as a dual-damascene approach providing cost savings. For example, this results in the second and third metallization layers 112, 124 being formed at the same time together as a single unitary structure.

In view of the above discussion, in at least one embodiment, the second metallization layer 112 and the third metallization layer 124 are formed in two separate deposition steps, which may be referred to as a double single-damascene approach. For example, this results in the second and third metallization layers 112, 124 being formed at separate deposition steps of this approach.

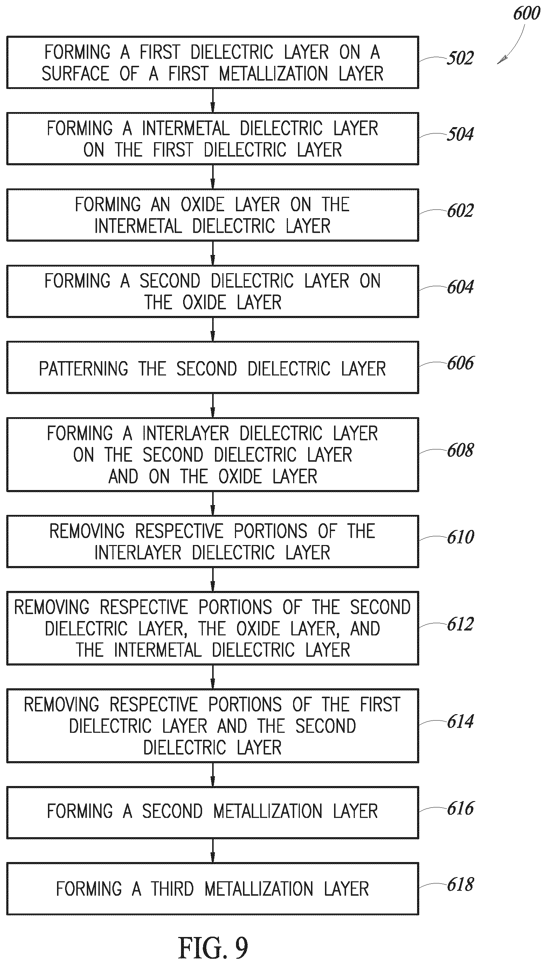

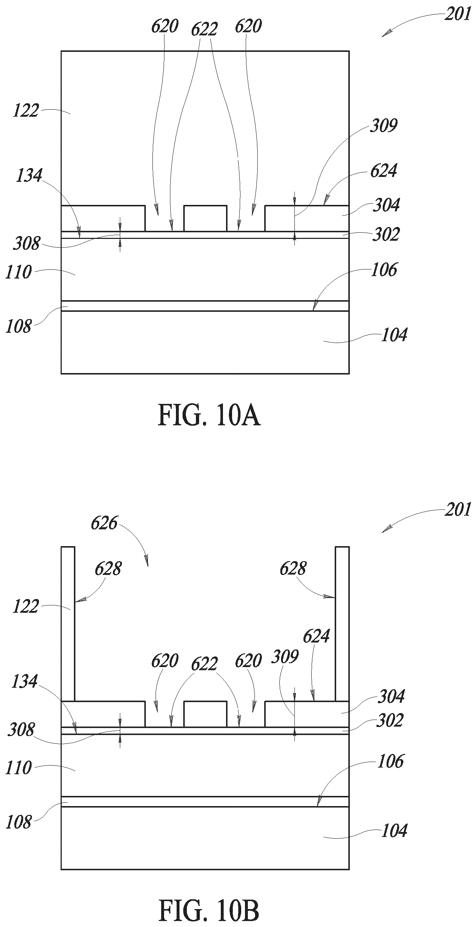

Figure 9 is a flowchart 600 of an alternative embodiment of a method of manufacturing the alternative embodiment of the metallization structure 300 as shown in Figures 5A and 5B of the present disclosure. Figures 10A-10E are cross-sectional views of intermediate steps throughout the embodiment of the method of manufacturing of the flowchart 600 as shown in Figure 9.

As the first step 502 and the second step 504, respectively, at the first region 201 are the same as the first step 502 and the second step 504, respectively, at the first region 201 and the second region 202 as discussed earlier herein with respect to Figure 7, for the sake of simplicity and brevity of the present disclosure, the discussion of the first step 502 and the second step 504 are not reproduced herein.

In the third step 602, the third dielectric layer 302 (or first dielectric sub-layer) is formed on and along the surface 134 of the intermetal dielectric layer 110 at the first region 201. In at least one embodiment, the third dielectric layer 302 is formed by a deposition technique (e.g., ALD, Atomic Layer Deposition) known within the semiconductor industry to form the third dielectric layer 302 onto the surface 134 of the intermetal dielectric layer 110 at the first region 201.

In the fourth step 604, the second dielectric layer 304 (or second dielectric sub-layer) is formed on the third dielectric layer 302 at the first region 201, e.g., by utilizing a deposition technique (*e.g.*, CVD, Chemical Vapor Deposition). After the third dielectric layer 302 has been formed, the third dielectric layer 302 may have the third dimension 308.

In a fifth step 606 (schematically shown in fig. 10A), the second dielectric layer 304 (or second dielectric sub-layer) is patterned at the first region 201 to form one or more openings 620 that expose one or more corresponding regions 622 of the third dielectric layer 302. The one or more openings 620 extend into a surface 624 of the second dielectric layer 304 and extend fully through the second dielectric layer 304 to the third dielectric layer 302 exposing the one or more regions 622 of the third dielectric layer 302. After the fourth step 604 is carried out forming the second dielectric layer 304, the second dielectric layer 304 has the fourth dimension 309 along its entirety at this stage of the embodiment of the method of manufacturing in the flowchart 600. The second dielectric layer 304 is not patterned with the one or more openings 620 at the second region 202. The second dielectric layer 304 may be patterned with the one or more openings 620 by forming a resist mask layer on the surface 624, patterning the resist mask layer with one or more openings corresponding to the one or more openings 620 to be formed, and then etching through the one or more openings in the resist mask layer to remove respective portions of the second dielectric layer 304 to form the one or more openings 620.

In the sixth step 608 (see fig. 10A), the interlayer dielectric layer 122 is formed (e.g., by deposition such as by CVD) on the surface 624 of the second dielectric layer 304, is formed within the one or more openings 620, and is formed on the one or more regions 622 of the third dielectric layer 302 at the first region 201.

In the seventh step 610 (see fig. 10B), respective portions of the interlayer dielectric layer 122 are removed at the first region 201 (in a similar way as disclosed with reference to fig. 8B).

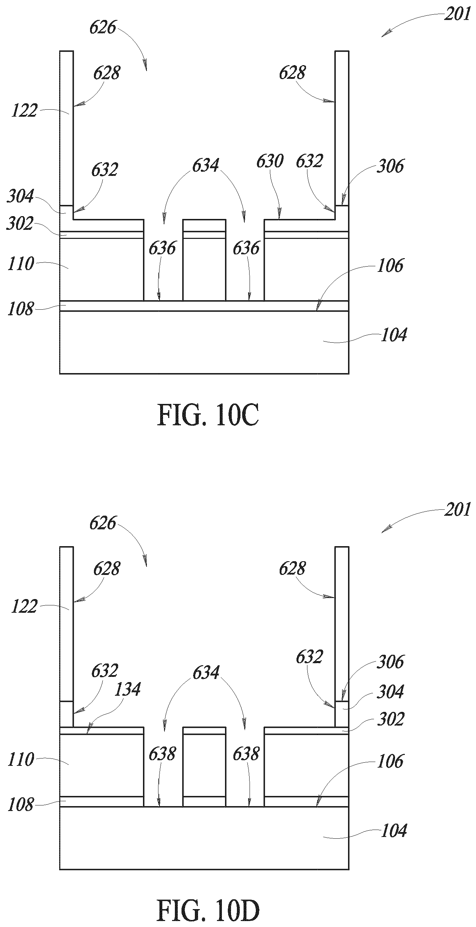

In the eighth step 612, respective portions (aligned with the openings 620) of the intermetal dielectric layer 110, and the third dielectric layer 302 are removed. The respective portions are removed by using respective etchant chemicals and this etching results in a portion of the second dielectric layer 304 being removed, which defines (after all the etching steps) a recessed surface 630, defines the end 306, and partially defines the second dielectric layer 304 as shown in Figure 5A. The etching results in one or more sidewalls 632 being formed. The etching further results in partially forming and defining via openings 634 that extend through the second dielectric layer 304, the third dielectric layer 302, and the intermetal dielectric layer 110 to the first dielectric layer 108. The partially formed and defined via openings 634 expose one or more regions 636 of the first dielectric layer 108. The partially formed and defined via openings 634 are delimited and defined by respective sidewalls of the second dielectric layer 304, the third dielectric layer 302, and the intermetal dielectric layer 110. The intermediate structure at the first region 201 formed as a result of carrying out the eighth step 612 may be readily seen in Figure 10C of the present disclosure.

In the ninth step 614, respective portions of the second dielectric layer 304 and the first dielectric layer 108 are removed at the first region 201. For example, in at least one embodiment, the second dielectric layer 304 and the first dielectric layer 108 are exposed to an etchant chemical resulting in the respective portions of the second dielectric layer 304 and the first dielectric layer 108 being etched away. This etching results in exposing one or more regions 638 along the surface 106 of the first metallization layer 104 and exposing a majority of the third dielectric layer 302 at the first region 201. The removal of the respective portions of the first dielectric layer 108 results in fully forming and defining the via openings 634. In other words, after the respective portions of the first dielectric layer 108 have been removed, the fully formed and defined via openings 634 are delimited and defined by respective sidewalls of the first dielectric layer 108, the intermetal dielectric layer 110, and the third dielectric layer 302. The removal of the respective portion of the second dielectric layer 304 in the ninth step 614 results in the formation of the second dielectric layer 304 as shown in Figure 5A of the present disclosure. In the ninth step 614, the one or more sidewalls 632 increase in size. The intermediate structure at the first region 201 formed as a result of carrying out the ninth step 614 may be readily seen in Figure 10D of the present disclosure.

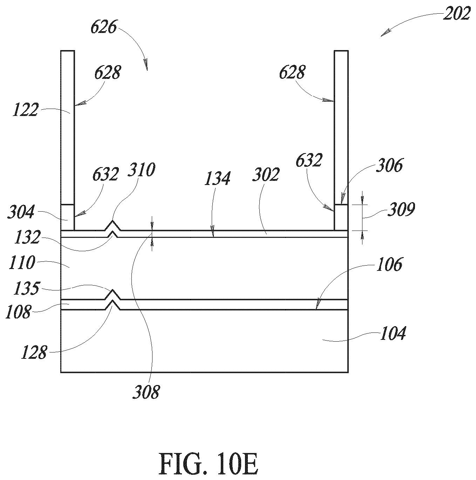

It will be readily appreciated that the first, second, third, fourth, sixth, seventh, eighth, and ninth steps 502, 504, 602, 604, 608, 610, 612, 614 are carried out at the second region 202 as well. The results of carrying out these steps result in the intermediate structure as shown in Figure 10E. The intermediate structure formed by carrying out these respective steps at the second region 202 may be readily seen in Figure 10E.

After the alternative embodiment of the method of manufacturing of the flowchart 600 is carried out to completion through the ninth step 614 at the first region 201 and the second region 202, in the tenth step 616 and the eleventh step 618, the second metallization layer 112 and the third metallization layer 124 are respectively formed within the via openings 634. These steps are carried out as described above with reference to the first embodiment.

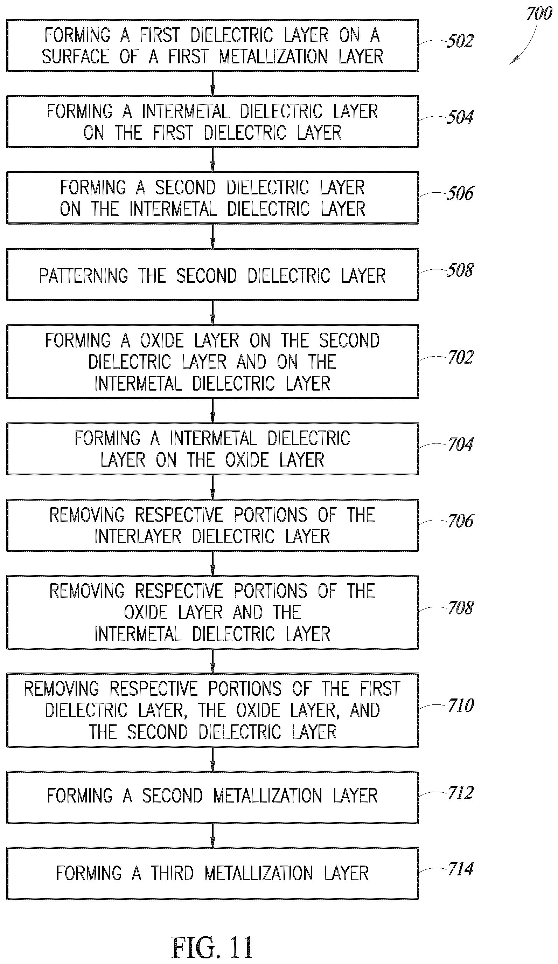

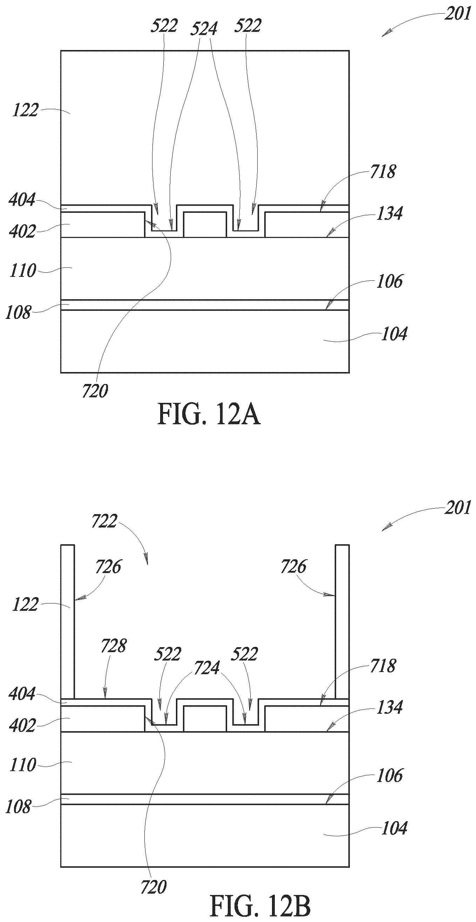

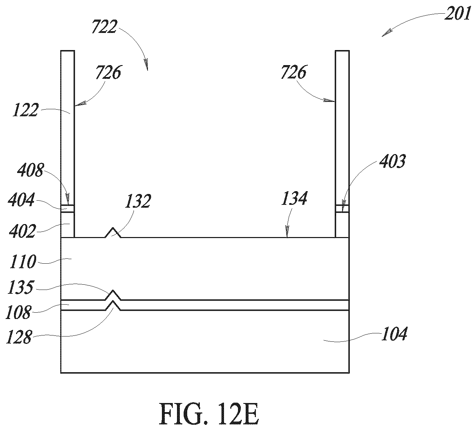

Figure 11 is a flowchart 700 of another alternative embodiment of a method of manufacturing the another alternative embodiment of the metallization structure 400 as shown in Figures 6A and 6B of the present disclosure. Figures 12A-12E are cross-sectional views of intermediate steps throughout the embodiment of the method of manufacturing of the flowchart 700 as shown in Figure 11.

As the first step 502, the second step 504, the third step 506, and the fourth step 508, respectively, at the first region 201 are the same as the first step 502, the second step 504, the third step 506, and the fourth step 508, respectively, at the first region 201 and the second region 202 as discussed earlier herein with respect to Figure 7, for the sake of simplicity and brevity of the present disclosure, the discussion of the first step 502, the second step 504, the third step 506, and the fourth step 508 are not reproduced herein.

In the fifth step 702 at the first region 201, the third dielectric layer 404 (or fourth dielectric sub-layer) is formed on a surface 718 of the second dielectric layer 402 (or third dielectric sub-layer) and is formed within the one or more openings 522 patterned into the second dielectric layer 402 in the fourth step 508. The third dielectric layer 404 is formed on the one or more regions 524 of the intermetal dielectric layer 110 exposed from the second dielectric layer 402 when the one or more openings 522 are formed in the second dielectric layer 402 in the fourth step 508. The third dielectric layer 404 is formed on one or more sidewalls 720 that define and delimit the one or more openings 522 before the third dielectric layer 404 has been formed in the fifth step 702. In at least one embodiment, the third dielectric layer 404 is formed by a deposition technique (e.g., ALD, Atomic Layer Deposition) known within the semiconductor industry to form the third dielectric layer 404 onto the second dielectric layer 402 and the intermetal dielectric layer 110 at the first region 201.

In the sixth step 704 at the first region 201 (see fig. 12A), the interlayer dielectric layer 122 is formed (e.g., by deposition such as by CVD) on the third dielectric layer 404 and is formed in the one or more openings 522.

In the seventh step 706 at the first region 201, respective portions of the interlayer dielectric layer 122 are removed (in a similar way as disclosed with reference to figs 8B).

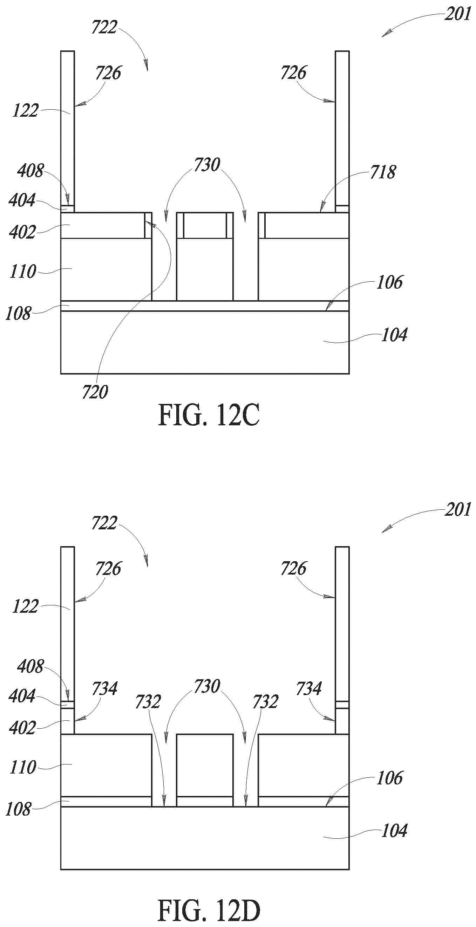

In the eighth step 708 (fig.12C) at the first region 201, respective portions (aligned with openings 522) of the intermetal dielectric layer 110, and the third dielectric layer 404 are removed. The respective portions are removed by using respective etchant chemicals and this etching results in respective portions of the third dielectric layer 404 being removed, at least partially exposing the surface 718 of the second dielectric layer 402. Removing these respective portions of the third dielectric layer 404 results in defining the end 408 of the third dielectric layer 404. After these respective portions of the third dielectric layer 404 have been removed, remaining respective portions of the third dielectric layer 404 remain present on and along the one or more sidewalls 720 of the second dielectric layer 402. The etching further results in partially forming and defining via openings 730 that extend through the second dielectric layer 304, the third dielectric layer 302, and the intermetal dielectric layer 110 to the first dielectric layer 108. The partially formed and defined via openings 634 expose one or more regions 636 of the first dielectric layer 108. The partially formed and defined via openings 730 are delimited and defined by respective sidewalls of the second dielectric layer 402, the third dielectric layer 404, and the intermetal dielectric layer 110. The intermediate structure at the first region 201 formed as a result of carrying out the eighth step 708 may be readily seen in Figure 12C of the present disclosure.

In the ninth step 710 at the first region 201, respective portions of the third dielectric layer 404, the second dielectric layer 402, and the first dielectric layer 108 are removed at the first region 201. For example, in at least one embodiment, the third dielectric layer 404, the second dielectric layer 402, and the first dielectric layer 108 are exposed to an etchant chemical resulting in the respective portions of the third dielectric layer 404, the second dielectric layer 402, and the first dielectric layer 108 being etched away. This etching results in exposing one or more regions 732 along the surface 106 of the first metallization layer 104 by removing a majority of the second dielectric layer 402 at the first region 201. The removal of the respective portions of the first dielectric layer 108 results in fully forming and defining the via openings 730. In other words, after the respective portions of the first dielectric layer 108 have been removed, the fully formed and defined via openings 730 are delimited and defined by respective sidewalls of the first dielectric layer 108 and the intermetal dielectric layer 110. The removal of the respective portions of the second dielectric layer 402 in the ninth step 710 results in the formation of the second dielectric layer 402 and the third dielectric layer 404 as shown in Figure 6A of the present disclosure. In the ninth step 710, one or more sidewalls 734 of the second dielectric layer 402 are formed and defined. The intermediate structure at the first region 201 formed as a result of carrying out the ninth step 710 may be readily seen in Figure 12D of the present disclosure.

It will be readily appreciated that the first, second, third, fourth, sixth, seventh, eighth, and ninth steps 502, 504, 602, 604, 608, 610, 612, 614 are carried out at the second region 202 as well. The results of carrying out these steps result in the intermediate structure as shown in Figure 10E. The intermediate structure formed by carrying out these respective steps at the second region 202 may be readily seen in Figure 10E.

After the another alternative embodiment of the method of manufacturing of the flowchart 700 is carried out to completion through the ninth step 710 at the first region 201 and the second region 202, in the tenth step 712 and eleventh step 714, the second metallization layer 112 and the third metallization layer 124 are respectively formed within the via openings 730. These steps are carried out as described above with reference to the first embodiment.

The one or more pillar defects 130 are not formed when forming the metallization structure 200, 300, and 400. For example, the protective dielectric layer that is present on the surface 134 of the intermetal dielectric layer 110 (see Figure 8B/10B/12B of the present disclosure) acts as a barrier reducing the likelihood of or preventing the formation of the pillar defect recesses 138 as shown in Figure 3 when forming the one or more via openings, which ultimately reduces the likelihood of or prevents the formation of the one or more pillar defects 130 and consequently prevents or reduces the likelihood of short circuiting or cross-talk between various conductive structures and/or improves a yield number of a semiconductor manufacturing plant, and improves efficiency of electronic devices by reducing resistance along electrical pathways of the electronic devices.

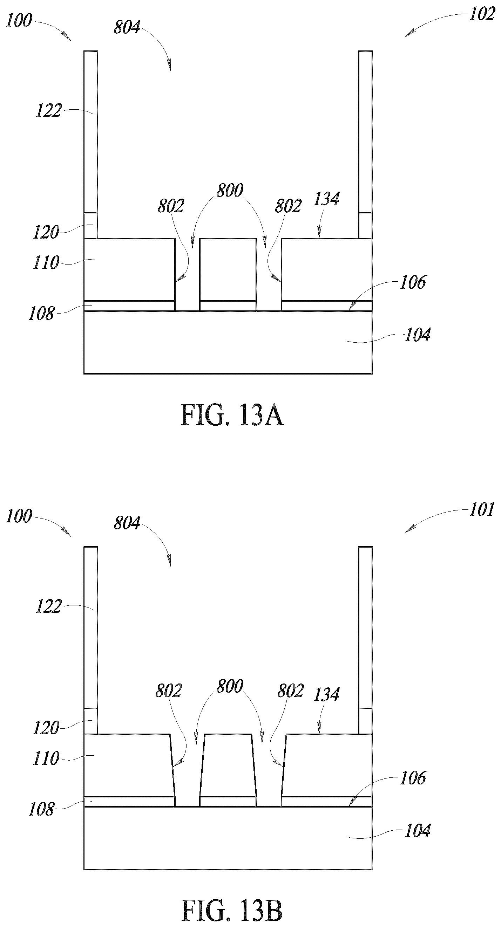

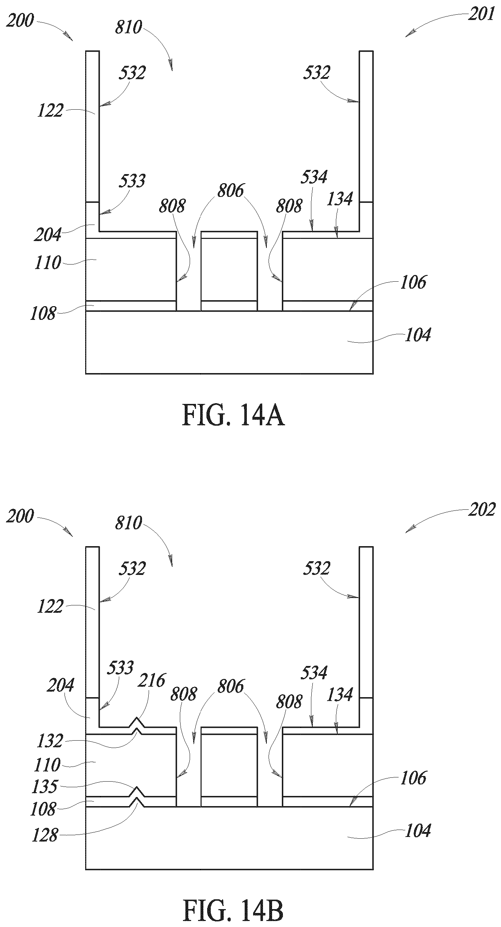

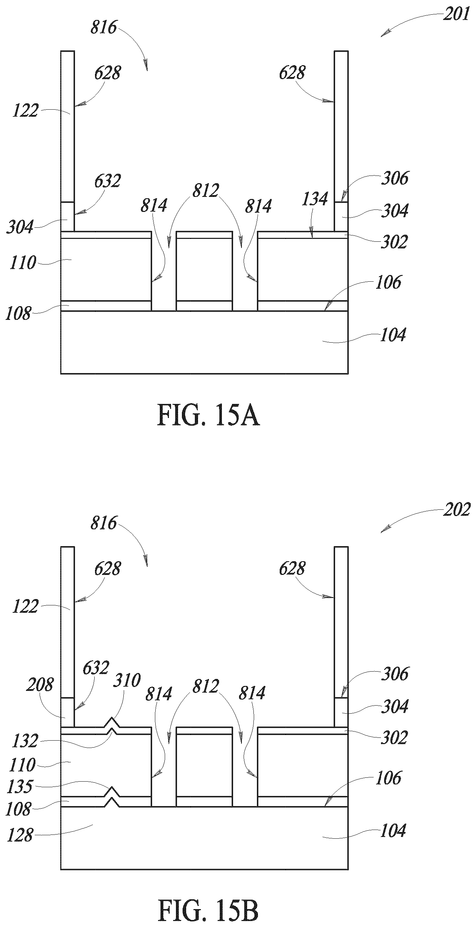

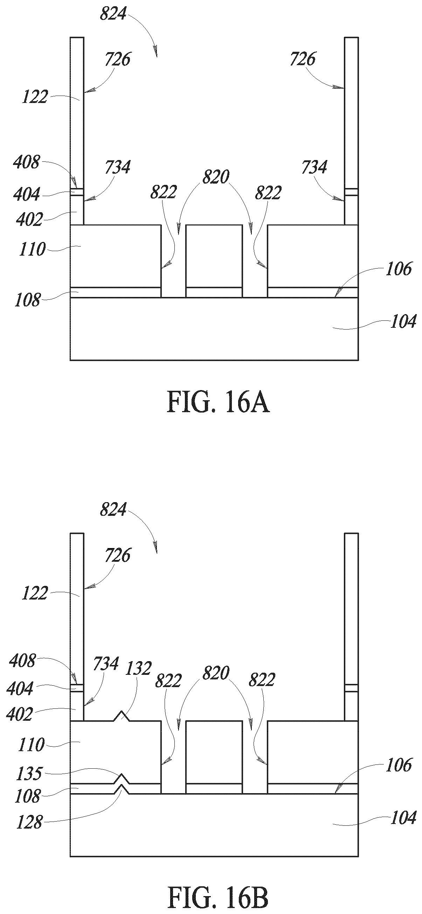

Another advantage of the presence of the protective dielectric layer according to the above disclosure is shown with reference to figures 13A-16B. In fact, the protective dielectric layer allows obtaining openings 800 having substantially vertical sidewalls independently of the position in the wafer (e.g., edge portion or central portion of the wafer). In fact, with reference to figure 13A-B is shown that, in absence of the protective dielectric layer, the vias of devices created at the central portion of the wafer (fig. 13A) have the desired shape (vertical sidewalls) but those of devices created at the edge portion of the wafer (fig. 13B) may have tapered sidewalls (wider top, narrower bottom). According to the Applicant, the tapered shape will cause a non-uniform resistance of the conductive vias through the different devices created on the wafers which could impair efficiency and accuracy of the production process. Moreover, the shape of the vias may cause issue on the transporting of an electrical signal through the metallization structures, which reduces the overall effectiveness and functionality of the metallization structures.

According to the present disclosure, the expressions "chemical nature" and "different chemical nature" refer to the chemical class of possible dielectric materials of which a certain dielectric layer is made of. For example, the second dielectric layer is made of a material belonging a first chemical class (e.g., it is a nitride layer), while the intermetal dielectric layer and/or the interlayer dielectric layer are made of a material belonging to a second chemical class (e.g., they are an oxide layer, e.g., a silicon oxide layer) different from the first chemical class.

According to the present disclosure, the expression "different chemical nature" referred to two materials means that the materials belong to two different chemical classes (e.g., one oxide and one nitride). According to the present disclosure, the expression "chemically different" referred to two materials means that the two materials belong to the same chemical class of material (e.g., both oxide materials) but comprise at least one structural element (i.e., an element with a stochiometric percentage of at least 20%) different from each other (e.g., aluminum oxide and silicon oxide).

According to the present disclosure, the metallization layers (e.g., the first and/or second metallization layers) and structures are preferably made of a Copper (Cu) material or a Copper (Cu) alloy material. However, the metallization layers and structures in some situations are made of some other type of conductive material suitable for the metallization layers and structures.

According to the present disclosure, the device comprises Back-End (BE) module having a number of metallization layers equal to "n", "n" being a natural number greater than 1 (and typically lower than or equal to 8).

In at least one embodiment, the first and third metallization layers are part of the Back-End module and correspond to a "n-1" metallization layer and to a "n" metallization layer of the Back-End module. For example, the device has a BE module comprising five metallization lines, with the first metallization layer corresponding to a fourth metallization line and the third metallization layer corresponding to a fifth metallization line. In other words, the above discussion preferably applies to the last metal level of the BE module of the device. This is due to the fact that the last metal level is the thicker one in the BE module of the device, and therefore higher thermal budget (responsible for the Cu-hillocks) are applied. The invention allows therefore to at least mitigate the formation of Cu-hillocks.

At least one embodiment of the present disclosure is summarized as a device, including: a first metallization layer having a surface; a first dielectric layer on the surface of the first metallization layer; an intermetal dielectric layer on the first dielectric layer; a second dielectric layer on the intermetal dielectric layer, wherein the second dielectric layer has a chemical nature different from a chemical nature of the intermetal dielectric layer; an interlayer dielectric layer on the second dielectric layer, wherein the interlayer dielectric layer has a respective chemical nature different from the chemical nature of the second dielectric layer; a second metallization layer extending into and through the second dielectric layer, the intermetal dielectric layer, and the first dielectric layer; and a third metallization layer extending through the interlayer dielectric layer to the second dielectric layer and the second metallization layer, the third metallization layer abutting the second dielectric layer, the third metallization layer in electrical communication with the first metallization layer through the second metallization layer, and the third metallization layer separated from the intermetal dielectric layer by the second dielectric layer.

The second metallization layer includes one or more conductive vias that extend through the second dielectric layer, the intermetal dielectric layer, and the first dielectric layer, and the third metallization layer is in electrical communication with the first metallization layer through the one or more conductive vias, wherein the one or more conductive vias include one or more sidewalls, and the one or more sidewalls are covered by the first dielectric layer, the intermetal dielectric layer, and the second dielectric layer.

The second dielectric layer is made of a nitride material and wherein the intermetal dielectric layer and the interlayer dielectric layer are made of an oxide material.

The second dielectric layer includes a first portion that extends along the intermetal dielectric layer, and a second portion that extends outward from the first portion, wherein the third metallization layer is separated from the intermetal dielectric layer by the first portion of the second dielectric layer.

The device further including a Back-End module having a number of metallization layers equal to "n", with "n" being a natural number greater than 1 (typically lower than or equal to 8), wherein the first and third metallization layers are part of to the Back-End module and correspond to a "n-1" metallization layer and to a "n" metallization layer of the Back-End module.

The third metallization layer includes one or more sidewalls, the one or more sidewalls being at least partially covered by the second portion of the second dielectric layer and at least partially covered by the interlayer dielectric layer.

The first portion has a thickness within a range of 20 nanometers (nm) to 150 nanometers (nm), inclusive of upper and lower ends of the range.

At least one embodiment of the present disclosure is summarized as a device, including: a first metallization layer having a surface; a first dielectric layer on the surface of the first metallization layer; an intermetal dielectric layer on the first dielectric layer; a third dielectric layer on the intermetal dielectric layer; a second dielectric layer on the third dielectric layer, wherein the second dielectric layer has a chemical nature different from a chemical nature of the third dielectric layer, the second dielectric layer separated from the intermetal dielectric layer by the third dielectric layer, and the second dielectric layer extending outward from the third dielectric layer and away from the intermetal dielectric layer; an interlayer dielectric layer on the second dielectric layer, wherein the interlayer dielectric layer has a respective chemical nature different from the chemical nature of the second dielectric layer; and a second metallization layer extending into and through the third dielectric layer, the intermetal dielectric layer, and the first dielectric layer and a third metallization layer extending through the interlayer dielectric layer and the second dielectric layer to the third dielectric layer and the second metallization layer, the third metallization layer abutting the third dielectric layer, the third metallization layer coupled to the second metallization layer, the third metallization layer in electrical communication with the first metallization layer through the second metallization layer, and the third metallization layer separated from the intermetal dielectric layer by the third dielectric layer.

The second metallization layer includes one or more conductive vias that extend through the third dielectric layer, the intermetal dielectric layer, and the first dielectric layer, and the third metallization layer is in electrical communication with the first metallization layer through the one or more conductive vias, and wherein the one or more conductive vias include one or more sidewalls, and the one or more sidewalls are covered by the first dielectric layer, the intermetal dielectric layer, and the third dielectric layer.

The third dielectric layer is an aluminum-based oxide, and wherein the second dielectric layer is made of a nitride material and wherein the intermetal dielectric layer and the interlayer dielectric layer are made of an oxide material.

The third metallization layer includes one or more sidewalls, the one or more sidewalls being at least partially covered by the second dielectric layer and at least partially by the interlayer dielectric layer.

The second dielectric layer is separated from the intermetal dielectric layer by the third dielectric layer.

The third dielectric layer has a thickness within a range of 20 nanometers (nm) to 100 nanometers, inclusive of upper and lower ends of the range.

The second dielectric layer has a thickness within a range of 120 nanometers (nm) to 250 nanometers (nm), inclusive of upper and lower ends of the range.

At least one embodiment of the present disclosure is summarized as a device, including: a first metallization layer having a surface; a first dielectric layer on the surface of the first metallization layer; an intermetal dielectric layer on the first dielectric layer; a second metallization layer extending through the intermetal dielectric layer and the first dielectric layer to the first metallization layer, a third metallization layer on the second metallization layer and on the intermetal dielectric layer, the third metallization layer abutting the intermetal dielectric layer and coupled to the second metallization layer, the third metallization layer in electrical communication with the first metallization layer through the second metallization layer, the third metallization layer including one or more sidewalls; a second dielectric layer on the intermetal dielectric layer, wherein the second dielectric layer has a chemical nature different from a chemical nature of the intermetal dielectric layer; a third dielectric layer on the second dielectric layer; and an interlayer dielectric layer on the third dielectric layer, wherein the interlayer dielectric layer is made of a material chemically different from a material of third dielectric layer, and the second dielectric layer, the third dielectric layer, and the interlayer dielectric layer at least partially covering the one or more sidewalls of the third metallization layer.

The second metallization layer includes one or more conductive vias that extend through the intermetal dielectric layer and the first dielectric layer, and the third metallization layer is in electrical communication with the first metallization layer through the one or more conductive vias.

The third dielectric layer is separated from the intermetal dielectric layer by the second dielectric layer.

The second dielectric layer has a thickness within a range of 120 nanometers (nm) to 250 nanometers (nm), inclusive of upper and lower ends of the range.

The third dielectric layer has a thickness within a range of 20 nanometers (nm) to 100 nanometers (nm), inclusive of upper and lower ends of the range.

At least one embodiment of the present disclosure is summarized as a method, including: forming a first dielectric layer on a surface of a first metallization layer; forming an intermetal dielectric layer on the first dielectric layer; forming a second dielectric layer on the intermetal dielectric layer, the second dielectric layer having a chemical nature different from a chemical nature of the intermetal dielectric layer, wherein a thickness of the second dielectric layer is greater than or equal to 120 nanometers (nm); patterning the second dielectric layer with one or more openings, thus exposing respective one or more portions of the intermetal dielectric layer; forming an interlayer dielectric layer on the second dielectric layer and in the one or more openings; patterning the interlayer dielectric layer to form a first opening in the interlayer dielectric layer and in the intermetal dielectric layer, wherein forming the first opening comprises: forming a recess by removing a portion of the interlayer dielectric layer extending from a top surface of the interlayer dielectric layer to the second dielectric layer, forming one or more through openings by: removing respective portions of the interlayer dielectric layer extending in the one or more openings of the second dielectric layer, removing the one or more portions of the intermediate dielectric layer at the one or more openings in the second dielectric layer, thus exposing portions of the first dielectric layer, and removing the exposed portions of the first dielectric layer to expose the first metallization layer; forming a second metallization layer extending in the one or more through openings of the first opening, and forming a third metallization layer in the recess of the first opening.

During patterning the ILD layer and during forming the first opening, the second dielectric layer is thinned to define a first portion of the second dielectric layer between the recess and the intermetal dielectric layer and a second portion of the second dielectric layer extending outward from the first portion and away from the intermetal dielectric layer, wherein forming the third metallization layer in the recess further includes forming the third metallization layer on the first portion of the second dielectric layer, and the third metallization layer having one or more sidewalls at least partially covered by the second portion of the second metallization layer and the interlayer dielectric layer, and wherein the third metallization layer is separated from the intermetal dielectric layer by the first portion of the second dielectric layer.

The second dielectric layer is made of a nitride material and wherein the intermetal dielectric layer and the interlayer dielectric layer are made of an oxide material.

A thickness of the second dielectric layer before patterning the second dielectric layer is in the range from 120 nm to 250 nm.

At least one embodiment of the present disclosure is summarized as a method, including: forming a first dielectric layer on a surface of a first metallization layer; forming an intermetal dielectric layer on the first dielectric layer; forming a third dielectric layer on the intermetal dielectric layer; forming a second dielectric layer on the third dielectric layer; patterning the second dielectric layer with one or more openings exposing one or more regions of the third dielectric layer; forming an interlayer dielectric layer on the second dielectric layer, in the one or more openings, and on the one or more regions of the third dielectric layer; patterning the interlayer dielectric layer to form a first opening in the interlayer dielectric layer and in the intermetal dielectric layer, wherein forming the first opening comprises: forming a recess by removing a portion of the interlayer dielectric layer extending from a top surface of the interlayer dielectric layer to the second dielectric layer and to the one or more regions of the third dielectric layer, forming one or more through openings by: removing the one or more regions of the third dielectric layer to expose one or more portions of the intermediate dielectric layer, removing the one or more portions of the intermediate dielectric layer at the one or more regions of the third dielectric layer, thus exposing portions of the first dielectric layer, and removing the exposed portions of the first dielectric layer to expose the first metallization layer; forming a second metallization layer extending in the one or more through openings of the first opening, and forming a third metallization layer in the recess of the first opening.

The method further including, during patterning the interlayer dielectric layer and during removing the exposed portions of the first dielectric layer, removing the second dielectric layer in the first opening exposing the third dielectric layer.

The forming the third metallization layer further includes forming the third metallization layer on the third dielectric layer, wherein the third dielectric is made of alumina (Al2O3).

At least one embodiment of the present disclosure is summarized as a method, including: forming a first dielectric layer on a surface of a first metallization layer; forming an intermetal dielectric layer on the first dielectric layer; forming a second dielectric layer on the intermetal dielectric layer; patterning the second dielectric layer with one or more openings exposing one or more regions of the intermetal dielectric layer; forming a third dielectric layer on the second dielectric layer and on the one or more regions of the intermetal dielectric layer; forming an interlayer dielectric layer on the third dielectric layer and in the one or more openings; patterning the interlayer dielectric layer to form a first opening in the interlayer dielectric layer and in the intermetal dielectric layer, wherein forming the first opening comprises: forming a recess by removing a portion of the interlayer dielectric layer extending from a top surface of the interlayer dielectric layer to the third dielectric layer, forming one or more through openings by: removing the third dielectric layer in the one or more openings exposing one or more portions of the intermediate dielectric layer, removing the exposed one or more portions of the intermediate dielectric layer, thus exposing portions of the first dielectric layer, and removing the exposed portions of the first dielectric layer to expose the first metallization layer, forming a second metallization layer extending in the one or more through openings of the first opening, and forming a third metallization layer in the recess of the first opening.

The third dielectric is made of alumina (Al2O3) and wherein, during removing the third dielectric layer in the one or more openings, the third dielectric layer is removed from a top surface of the second dielectric layer.

The third metallization layer includes one or more sidewalls at least partially covered by the interlayer dielectric layer, the oxide layer, and the second dielectric layer.

The various embodiments described above can be combined to provide further embodiments. Aspects of the embodiments can be modified, if necessary to employ concepts of the various patents, applications and publications to provide yet further embodiments.

These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. A method of manufacturing an electronic device (200, 300, 400), comprising the steps of:
forming a first metallization layer (104) having a surface (106);
forming a first dielectric layer (108) on the surface (106) of the first metallization layer (104);
forming an intermetal dielectric layer (110), IMD layer, on the first dielectric layer (108);
forming a protective dielectric layer (204; 302, 304; 402, 404) on the IMD layer (110), the protective dielectric layer (204; 302, 304; 402, 404) including at least one dielectric region (204; 302; 404) having a chemical nature different from a chemical nature of the IMD layer (110);
patterning, at least in part, the protective layer (204; 302; 404) to form at least one first opening (522; 620);
forming an interlayer dielectric layer (122), ILD layer, on the protective dielectric layer and in the at least one first opening (522; 620);
forming a second metallization layer (112) extending through the first dielectric layer (108), the IMD layer (110) and at least in part the protective dielectric layer (204; 302, 304; 402, 404) and a third metallization layer (124) extending through at least in part the protective dielectric layer (204; 302, 304; 402, 404) and the ILD layer (122), wherein the first (104) and third metallization layers (124) are in electrical contact through the second metallization layer (112).

2. The method according to claim 1, wherein the step of forming the second (112) and third metallization layers (124) comprises the step of forming a second opening (528, 536; 626, 634; 722, 730) extending through the ILD layer (122), the protective dielectric layer (204; 302, 304; 402, 404), the IMD layer (110) and the first dielectric layer (108) to expose portions (538; 638; 732) of the first metallization layer (104),
and wherein the step of forming the second opening comprises:
- forming a recess (528; 626; 722) by removing a portion of the ILD layer (122) extending from a top surface of the ILD layer (122) to the protective dielectric layer (204; 302, 304; 402, 404),
- forming at least one through hole (536; 626; 722) by removing in sequence: a respective portion of the ILD layer (122) in the at least one first opening (522; 620), a respective portion of the IMD layer (110), a respective portion of the first dielectric layer (108) to expose the first metallization layer,
wherein the second (112) and third metallization layers (124) are formed in the at least one through hole (536; 626; 722) and in the recess (528; 626; 722), respectively.

3. The method according to claim 2, wherein the protective dielectric layer comprises a second dielectric layer (204), wherein:
the step of forming the protective dielectric layer comprises depositing the second dielectric layer (204) on the IMD layer (110) with a thickness between 120 nm and 250 nm; and
the step of patterning, at least in part, the protective layer (204; 302; 404) to form the at least one first opening (522; 620) comprises etching the second dielectric layer (204) to expose portions of the IMD layer (110).

4. The method according to claim 3, wherein:
when the third metallization layer (124) has a thickness in the rannge 0.7 µm - 1.1 µm, the second dielectric layer (204) has a thickness in the range 120 nm - 160 nm; and/or
when the third metallization layer (124) has a thickness in the range 3.8 µm - 4.2 µm, the second dielectric layer (204) has a thickness in the range 200 nm - 250 nm, and/or
and wherein a ratio between the thicknesses of the second dielectric layer (204) and a respective thickness of the first dielectric layer (108) is greater than or equal to 1.2.

5. The method according to claim 3, wherein the second dielectric layer (204) is of a nitride material, preferably silicon nitride, and wherein the IMD layer (110) and the ILD layer (122) are of an oxide material, preferably silicon oxide.

6. The method according to claim 3, wherein the step of forming the recess (528; 626; 722) and the at least one through hole (536; 626; 722), comprises partially etching the second dielectric layer (204) so as to form a first portion (206) of the second dielectric layer (204) within the recess (528; 626; 722) and a second portion (208) of the second dielectric layer (204) outside of the recess (528; 626; 722), wherein the first portion (206) has a thickness smaller than a respective thickness of the second portion (208).

7. The method according to claim 6, wherein the thickness of the first portion (206) is in the range 50 nm - 150 nm and wherein the thickness of the second portion (208) is in the range 120 nm - 250 nm.

8. The method according to claim 2, wherein the protective layer (302, 304) comprises a first dielectric sub-layer (302) on the IMD layer (110) and a second dielectric sub-layer (304) on the first dielectric sub-layer (302), wherein the first dielectric sub-layer (302) is of an oxide material, preferably aluminum oxide, and the second dielectric sub-layer (304) is of a nitride material, preferably silicon nitride.

9. The method according to claim 8, wherein:
the step of forming the protective layer comprises conformally depositing the first dielectric sub-layer (302) on the IMD layer (110) and depositing the second dielectric sub-layer (304) on the first dielectric sub-layer (302),
the step of patterning, at least in part, the protective layer (204; 302; 404) to form at least one first opening (522; 620) comprises etching the second dielectric sub-layer (304) to expose respective portions of the first dielectric sub-layer (302),
the step of forming the recess (528; 626; 722) and the at least one through hole (536; 626; 722), further comprises etching through the first dielectric sub-layer (302) to expose respective portions of the IMD layer (110).

10. The method according to claim 2, wherein the protective layer (402, 404) comprises a third dielectric sub-layer (402) on the IMD layer (110) and a fourth dielectric sub-layer (404) on the first dielectric sub-layer (402), wherein the first dielectric sub-layer (402) is of a nitride material, preferably silicon nitride, and the second dielectric sub-layer (404) is of an oxide material, preferably aluminum oxide.

11. The method according to claim 10, wherein:
the step of forming the protective layer comprises depositing the first dielectric sub-layer (402) on the IMD layer (110),
the step of patterning the protective layer (204; 302; 404) to form at least one first opening (522; 620) comprises etching the first dielectric sub-layer (402) to expose respective portions of the IMD layer (110),
the step of forming the protective layer further comprises conformally depositing the second dielectric sub-layer (404) on the first dielectric sub-layer (402) and in the at least one first opening (522),
the step of forming the recess (528; 626; 722) and the at least one through hole (536; 626; 722), further comprises etching through the second dielectric sub-layer (404) to expose respective portions of the first dielectric sub-layer (402) and of the IMD layer (110), with portions of second dielectric sub-layer (404) being left on sidewalls of the at least one first opening (522).

12. An electronic device (200, 300, 400) comprising:
a first metallization layer (104) having a surface (106);
a first dielectric layer (108) on the surface (106) of the first metallization layer (104);
an intermetal dielectric layer (110), IMD layer, on the first dielectric layer (108);
a protective dielectric layer (204; 302, 304; 402, 404) on the IMD layer (110), the protective dielectric layer (204; 302, 304; 402, 404) having at least one dielectric region (204; 302; 404) having a chemical nature different from a chemical nature of the IMD layer (110);
an interlayer dielectric layer (122), ILD layer, on the protective dielectric layer (204; 302, 304; 402, 404),
a second metallization layer (112) extending through the first dielectric layer (108), the IMD layer (110) and at least in part the protective dielectric layer (204; 302, 304; 402, 404),
a third metallization layer (124) extending through at least in part the protective dielectric layer (204; 302, 304; 402, 404) and the ILD layer (122),
wherein the first (104) and third metallization layers (124) are in electrical contact through the second metallization layer (112).

13. The device according to claim 12, further comprising a module having a number of metallization layers equal to "n", with "n" being a natural number greater than 1 and lower than or equal to 8, wherein the first (104) and third metallization layers (124) are part of the module and correspond to a "n-1" metallization layer and to a "n" metallization layer of the module.

14. The device according to claim 12, wherein the protective dielectric layer comprises a second dielectric layer (204) comprising a first portion (206) extending between the IMD layer (110) and the third metallization layer (124) and a second portion (208) extending between the IMD layer (110) and the ILD layer (122), wherein the first portion (206) has a thickness smaller than a respective thickness of the second portion (208).

15. The device according to claim 14, wherein the thickness of the first portion (206) is in the range 50 nm - 150 nm and wherein the thickness of the second portion (208) is in the range 120 nm - 250 nm.
